(19) Europäisches Patentamt
European Patent Office
Office européen des brevets

(11) EP 1 612 623 A1

(12) **EUROPEAN PATENT APPLICATION**
published in accordance with Art. 158(3) EPC

(43) Date of publication:
**04.01.2006 Bulletin 2006/01**

(21) Application number: **04722984.4**

(22) Date of filing: **24.03.2004**

(51) Int Cl.:
*G03H 1/02* (1974.07) *G03H 1/04* (1974.07)

(86) International application number:
**PCT/JP2004/004065**

(87) International publication number:
**WO 2004/090646 (21.10.2004 Gazette 2004/43)**

(84) Designated Contracting States:
**AT BE BG CH CY CZ DE DK EE ES FI FR GB GR HU IE IT LI LU MC NL PL PT RO SE SI SK TR**
Designated Extension States:
**AL LT LV MK**

(30) Priority: **09.04.2003 JP 2003105006**
**10.07.2003 JP 2003194816**

(71) Applicant: **Konica Minolta Medical & Graphic, Inc.**
**Tokyo 163-0512 (JP)**

(72) Inventor: **TAKEYAMA, Toshihisa**
**Tokyo 191-8511 (JP)**

(74) Representative: **McCluskie, Gail Wilson**
**J.A. Kemp & Co.,**
**14 South Square,**
**Gray's Inn**
**London WC1R 5JJ (GB)**

# (54) HOLOGRAPHIC RECORDING MEDIUM AND RECORDING METHOD USING THE SAME

(57) A holographic recording medium containing a first substrate and a second substrate having a holographic recording layer between the first substrate and the second substrate, the holographic recording layer containing: (A) a binder compound having a reactive group capable of cationic polymerization; (B) a polymerizable compound having an ethylenic double bond in the molecule; (C) a photoinitiator; and (D) a cross-linking agent which reacts with the reactive group in the binder compound, the cross-linking agent being a thermal cationic polymerization initiator.

FIG. 1

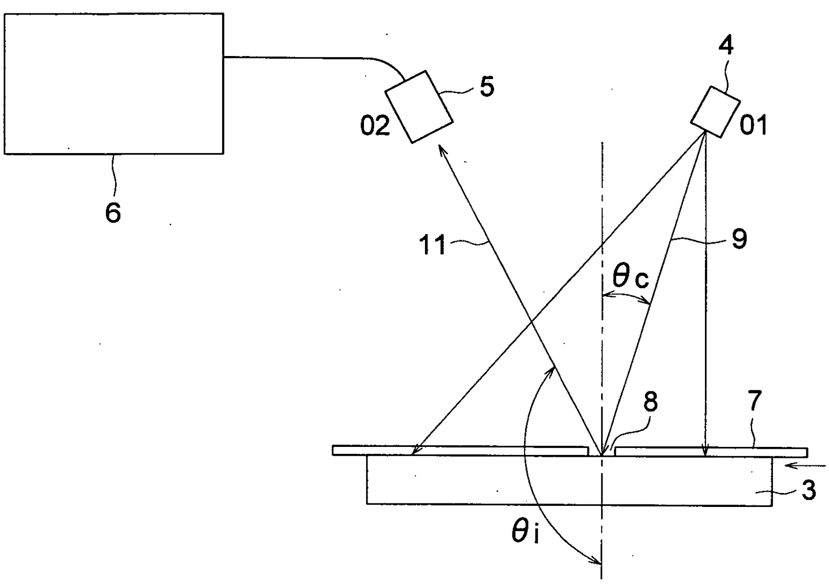


EP 1 612 623 A1

## Description

### TECHNICAL FIELD

The present invention relates to a holographic recording medium capable of providing a large amount of capacity as well as a holographic recording composition and a holographic recording method suitable for the holographic recording medium.

### BACKGROUND

In recent years, data access at high speed and of large capacity has been increasing due to popularization of inter-net or introduction of broad-band in inter-net. The data volume stored at each belonging organization has been rapidly increasing due to expansion of an electronic government promoted by the government of every nation in the world. Further, a recording medium having a large memory capacity is supposed to be required hereafter because of popularization of Hi-Vision in TV broadcasting and of terrestrial digital broadcasting. Under the current situation, photo-recording media of a new generation such as a Blu-ray disc are expected to prevail. As for recording media of the second next generation, various types of methods having been proposed but it is still hard to determine a leading candidate till now.

Among the recording media of the second or the third generation, memory system of a paging-style, specifically, holographic recording has been proposed as a substitute to conventional memory devices, and is attracting notice recently because it is a method having a high memory capacity and random access capability. This holographic recording is detailed in several review articles (for example, refer to non-patent literature 1).

There are proposed such as a recording method (for example, refer to patent literature 1) employing a holographic recording medium in which transparent substrates are arranged on both sides of a holographic recording layer, and a recording medium (for example, refer to patent literature 2) employing a holographic recording medium having a reflection plane arranged on one side of a holographic recording layer. In these recording media, a holographic recording layer is one of the key technologies to control the performance.

Such a holographic recording layer employs a basic principle to record information by changing the refractive index of the inside of the layer by holographic exposure and regenerate the information by reading out the change of the refractive index in the recorded medium. Proposed examples as a holographic recording layer are various types such as materials utilizing inorganic materials (for example, refer to patent literature 3), materials utilizing compounds which structurally isomerize with light (for example, refer to patent literature 4) or materials utilizing diffusion polymerization of photopolymers (for example, refer to patent literature 5). Among them, in the materials utilizing photopolymers described in patent literature 5, the thickness of the material is restricted up to approximately 150 μm, since a volatile solvent is employed at the preparation of the recording layer forming composition. Further, volume shrinkage of 4 - 10% caused by polymerization gave detrimental effects on the reliability at the time of regenerating the recorded information.

To overcome the aforesaid disadvantages, proposed is such as a holographic recording layer forming composition (for example, refer to patent literature 6), which employs cationic polymerization which utilizing no solvent and exhibits a relatively small volume shrinkage. However, since components other than the monomer which causes cationic photo-polymerization, are liquid substances in this recording layer forming composition, there was a fear that the island-form portions having been formed by photo-polymerization of the monomer in the recording layer with holographic exposure may migrate, or a problem that the liquid substances may expand due to ambient temperature change in the apparatus.

Therefore, there is proposed such as a composition (for example, refer to patent literature 7), in which radical polymerization is employed for recording at holographic exposure and a binder matrix is formed after the media formation to retain the monomer capable of radical polymerization before the exposure. Or there is proposed combined usage of a thermal expanding agent (for example, refer to patent literature 8). By utilizing this composition, the thickness of a holographic recording layer can be made heavy, and the volume shrinkage is small to enhance the reliability of the information obtained at the time of reproduction.

On the other hand, in the case of performing holographic recording on a holographic recording medium, it is indispensable to be able to expose at a lower energy to increase the recording speed. To increase the recording speed, in other words, the recording sensitivity, important are the selection and combination of a radical polymerizable monomer, a binder matrix, a sensitizing dye and a radical initiator. For example, there is proposed a holographic recording medium which makes use of photo cationic polymerization and photo radical polymerization at the same time (for example, refer to patent literature 9), however it is still to be improved.

[Patent literature 1] USP No. 5,719,691
[Patent literature 2] JP-A No. 2002-123949

[Patent literature 3] British Patent No. 9,929,953
[Patent literature 4] JP-A No. 10-340479
[Patent literature 5] USP No. 4,942,112
[Patent literature 6] USP No. 5,759,721
[Patent literature 7] USP No. 6,103,454
[Patent literature 8] USP No. 6,124,076
[Patent literature 9] JP-A No. 2003-66,816

[Non-patent literature 1]

Hans J. Coufal, et. al. "Holographic Data Storage (Springer Series in Optical Sciences, Vol. 76)", Springer-Verlag GmbH & Co. KG, (Aug. 2002)

The present invention has been made in view of the above-described problems, and a feature of the present invention is to provide holographic recording media having a high sensitivity and a low volume decreasing property, and a holographic recording method employing the same.

## DISCLOSURE OF THE INVENTION

The object of the present invention can be achieved by the following structures.

1. A holographic recording medium containing a first substrate and a second substrate having a holographic recording layer between the first substrate and the second substrate, the holographic recording layer containing:

(A) a binder compound having a reactive group capable of cationic polymerization;
(B) a polymerizable compound having an ethylenic double bond in the molecule;
(C) a photoinitiator; and
(D) a cross-linking agent which reacts with the reactive group in the binder compound, wherein the cross-linking agent is a thermal cationic polymerization initiator.

2. A holographic recording medium of the aforesaid item (1), wherein the thermal cationic polymerization initiator is a compound represented by Formula (1) or Formula (2):

Formula (1)

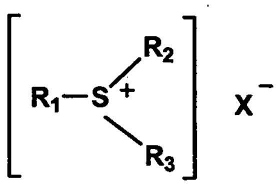

wherein R1 is a substituted or unsubstituted aromatic group, each R2 and R3 is independently a substituted or unsubstituted alkyl, cycloalkyl, aralkyl group, and $X^-$ is a counter anion;

Formula (2)

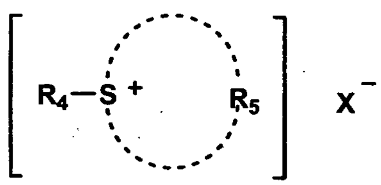

wherein R4 is a substituted or unsubstituted alkyl, cycloalkyl, aralkyl group, R5 is a substituted or unsubstituted hydrocarbon group which forms 5 or 6-membered ring with sulfur, and $X^-$ is a counter anion.

3. A holographic recording medium of the aforesaid item 2, wherein the holographic recording layer further contains an acid multiplying agent.

4. A holographic recording medium of the aforesaid item 1, wherein the holographic recording layer further contains a spectral sensitizing dye which spectrally sensitize the photoinitiator (c).

5. A holographic recording medium of the afore said item 1, wherein the reactive group in the binder compound (A) is selected from the group consisting of an epoxy, oxetane, vinyl ether, alkenyl ether, allene ether and keteneacetal group.

6. A holographic recording medium of the aforesaid item 5, wherein the binder compound (A) contains an oxetane group in the molecule.

7. A holographic recording medium of the aforesaid items 5 or 6, wherein the binder compound (A) is a liquid at 20°C or has a melting point of not more than 100 ° C.

8. A holographic recording medium of the aforesaid item 1, wherein the ethylenic double bond in the polymerizable compound (B) is an acryloyl or methacryloyl group.

9. A holographic recording medium of the aforesaid item 1, wherein the polymerizable compound (B) has a refractive index of not less than 1.55.

10. A holographic recording medium of the aforesaid item 1, wherein a thickness of the first substrate (d1), a thickness of the second substrate (d2) and a thickness of the holographic recording layer (Dh) satisfy the following formula:

$$0.15 \leq Dh/(d1 + d2) \leq 2.0$$

11. A holographic recording medium of the aforesaid item 10, wherein the thickness of the holographic recording layer (Dh) is 200 μm to 2.0 mm.

12. A holographic recording medium of the aforesaid item 10, wherein the thickness of the first substrate (d1) and the thickness of the second substrate (d2) satisfy the following formula:

$$d1 \leq d2$$

13. A holographic recording medium of the aforesaid item 1, wherein the first substrate is transparent and has an antireflective outer surface and an inner surface, the antireflective outer surface being opposite to the inner surface and the inner surface facing the holographic recording layer.

14. A holographic recording medium of the aforesaid item 1, wherein the first substrate is a glass plate.

15. A holographic recording medium of the aforesaid item 1, wherein an inner surface or an outer surface of the second substrate is coated with a reflective layer having a reflective index of not less than 70%, the inner surface being a surface which has the holographic recording layer thereon.

16. A holographic recording medium of the aforesaid item 1, wherein a shape of the holographic recording medium is a disc form.

17. A holographic recording medium of the aforesaid item 1, wherein a shape of the holographic recording medium is a card form.

18. A method of forming a holographic image using a holographic recording medium comprising a first substrate and a second substrate having a holographic recording layer between the two substrate, the holographic recording layer containing:

(A) a binder compound having a reactive group which is capable of cationic polymerization;
(B) a polymerizable compound having an ethylenic double bond in the molecule;
(C) a photoinitiator; and
(D) a cross-linking agent which reacts with the reactive group in the binder compound and further a thermal cationic polymerization initiator,

the method comprising the steps of:

(i) irradiating the holographic recording medium with a first light so as to cross-link the binder compound and the cross-linking agent, provided that the first light has not a property of activating the photoinitiator;
(ii) irradiating the holographic recording medium with a second light based on information to be recorded so as to activate the photoinitiator;
(iii) polymerizing the activated photoinitiator with the polymerizable compound(B) to form the holographic image.

19. A holographic image forming method of the aforesaid item 18, further comprising the step of:

(iv) irradiating the holographic recording medium with a light or subjecting the holographic recording medium so as to stabilize the holographic image after completion of the step (iii).

20. A method of forming a holographic image using a holographic recording medium comprising a first substrate and a second substrate having a holographic recording layer between the two substrate, the holographic recording layer containing:

(A) a binder compound having a reactive group which is capable of cationic polymerization;
(B) a polymerizable compound having an ethylenic double bond in the molecule;
(C) a photoinitiator; and
(D) a cross-linking agent which reacts with the reactive group in the binder compound and further a thermal cationic polymerization initiator,

the method comprising the steps of:

(i) irradiating the holographic recording medium with a light based on information to be recorded so as to activate the photoinitiator;
(ii) polymerizing the activated photoinitiator with the polymerizable compound to form the holographic image; and
(iii) irradiating the holographic recording medium with a light or subjecting the holographic recording medium so as to stabilize the holographic image after completion of the step (ii).

## BRIEF DESCRIPTION OF THE DRAWING

Fig. 1 is a schematic diagram presenting a principle of an apparatus for measuring a shrinkage ratio.

## PREFERRED EMBODIMENTS TO ACHIEVE THE INVENTION

In the following, a holographic recording medium of the present invention will be detailed.

The holographic recording composition employed in a recording layer of a holographic recording medium of the present invention is characterized by containing a binder compound (A) having a reactive group which can be cationic polymerized, a polymerizable compound (B) having an ethylenic double bond, a photo-polymerization initiator(C), and a cross-linking agent (D) which can react with the binder compound (A). The cross-linking agent (D) is a thermo cationic polymerization initiator which can start cationic polymerization by heating. The thermo cationic polymerization initiator has a property to produce an active species after being subjected to heat. The thermo cationic polymerization initiator is inactive to the polymerizable compound (B). The thermo cationic polymerization initiator is a compound which behaves as a cationic polymerization agent but does not behave as a radical polymerization agent.

Without any particular limitation, employed as thermal cationic polymerization initiators capable of cross-linking a binder compound (A), added as an essential component in the present invention, may be any of the conventional compounds known in the art, such as onium salts including sulfonium salts, ammonium salts, and phosphonium salts, or silanol-aluminum complexes as long as they do not adversely affect other essential components of the present invention. Of these thermal cationic polymerization initiators, when other essential components result in no problems while heated to a relatively high temperature of at least 150 °C, it is possible to select appropriate benzylsulfonium salts described in Japanese Patent Publication Open to Public Inspection (hereinafter referred to as JP-A) Nos. 58-37003 and 63-223002 and trialkylsulfonium salts described in JP-A No. 56-152833, and use any of them.

Further, when a photopolymerization initiator (C) is completely deactivated due to heating at a relatively high temperature, or radicals are generated due to heating at a relatively high temperature, preferable as thermal cationic polymerization initiators are compounds capable of initiating polymerization at a relatively low temperature. Of these, specifically, the compounds represented by aforesaid Formulas (1) and (2) are more preferred.

Alkyl groups in the compounds represented by aforesaid Formulas (1) and (2) include straight-chain and branched alkyl groups such as a methyl group, an ethyl group, a butyl group, an isopropyl group, a hexyl group, an octyl group, and a stearyl group. Further, preferred as cycloalkyl groups are those of a 5- to 7-membered ring and preferred as an aralkyl group is a benzyl group. Further, listed as aromatic groups are aromatic hydrocarbon groups such as a phenyl group or a naphthyl group comprised of hydrocarbon and aromatic groups such as a pyridine group or a thiophene group comprised of heterocyclic groups. Further, listed as substituents of the aforesaid functional groups may be a

halogen atom, a cyano group, a nitro group, an alkyl group, a hydroxyl group, an amino group (including an alkyl-substituted amino group), an alkenyl group, an alkynyl group, an alkoxy group, an alkylsulfonamido group, an arylsulfonamido group, an anilino group, an acylamino group, an alkylureido group, an arylureido group, an alkoxycarbonyl group, an alkoxycarbonylamino group, a carbamoyl group, a sulfamoyl group, a sulfo group, a carboxyl group, a carbamoyl group, COOR, -OCOR (wherein R is an organic group such as an alkyl group or an aryl group), an aryl group, and a heterocyclic group. Further, listed as counter anions represented by $X^-$ may be, for example, $Cl^-$, $Br^-$, $I^-$, $BF_4^-$, $PF_6^-$, $SbF_6^-$, $AsF_6^-$, $N_3^-$, $ClO_4^-$, $Cl_2Br^-$, $Cl_2I^-$, $BrI_2^-$, $Br_2I^-$, $Br_3^-$, $I_3^-$, $ICl_4^-$, $HSO_3^-$, $Ph_4B^-$, $SCN^-$, $NO_3^-$, $CH_3SO_3^-$, $CF_3SO_3^-$, p-$CH_3C_6H_4SO_3^-$, $CH_3COO^-$, $PHCOO^-$, $HOC_6H_4COO^-$, $AuI_2^-$, $ReO_4^-$, $Ph_3Si^-(F)_2$, and $Ph_3Sn^-(F)_2$. Of these, $BF_4^-$, $PF_6^-$, $SbF_6^-$, $AsF_6^-$, $Ph_4B^-$, $CF_3SO_3^-$, and p-$CH_3C_6H_4SO_3^-$ are preferred due to their relatively low nucleophilicity.

Listed as specific examples of the aforesaid thermal cationic polymerization initiators may be the compounds described in JP-A Nos. 63-8365, 63-8366, 1-83060, 1-290658, 2-1470, 2-196812, 2-232253, 3-17101, 3-47164, 3-48654, 3-145459, 3-200761, 3-237107, 4-1177, 4-210673, 8-188569, 8-188570, 11-29609, 11-255739, and 2001-55374. These thermal cationic polymerization initiators may be used individually or in combinations of at least two types.

Incidentally, the thermal cationic polymerization initiators detailed above are subjected to thermal cleavage to generate carbonium cations which are employed for the initiation of polymerization of binder compound (A). Further, when compounds having a proton providing functional group, such as a hydroxyl group, are present in holographic recording compositions, it is possible to use, as a cationic polymerization initiator of binder compound (A), protons which are formed by allowing carbonium cations formed due to the cleavage to react with compounds having a proton providing functional group.

Further, the added amount of the aforesaid thermal cationic polymerization initiators is customarily 0.1 - 30 parts by weight with respect to 100 parts by weight of binder compound (A) having a reactive group capable of achieving cationic polymerization, and is preferably in the range of 0.5 - 20 parts by weight.

Next, a binder compound (A) will be explained. The binder compound (A) has a reactive group which can be cationic polymerized, and is indispensable as a component of a holographic recording composition.

The aforesaid binder compounds are preferably liquid at ordinary temperature or have a melting point under 100 °C, because the holographic recording media of the present invention is produced by sandwiching a liquid composition at ordinary temperature or under 100 °C between two sheets of substrates at a predetermined thickness.

In order to control a precise thickness, the binder is required to be liquid during the production.

Further, it is preferable to partly fix the recording composition in a medium after formation of the medium or to fix the recorded information after holographic recording. As a means for such fixation, the objective can be achieved by making a cross-linking reaction between a binder compound (A) having a reactive group which can be cationic polymerized by a thermo cationic polymerization initiator.

Without any special limitation, employed as binder compounds (A) having a reactive group capable of achieving cationic polymerization, which are essential components of the present invention, may be any of the compounds which have a functional group capable of achieving cationic polymerization. Of these, preferred are those which have at least one reactive group selected from an epoxy group, an oxetane group, a vinyl ether group, an alkenyl ether group, an allene ether group, or a ketene acetal group. These may be selected as appropriate from prior art compounds used in various fields, and then used.

Furthermore, when a binder matrix with a high molecular weight is formed, it is preferable that compounds are incorporated which have at least one oxetane group in the molecule. Listed as specific examples of compounds having at least one oxetane group in the molecule may be the compounds described in JP-A Nos. 5-170763, 5-371224, 6-16804, 7-17958, 7-173279, 8-245783, 8-301859, 10-237056, 10-330485, 11-106380, 11-130766, 11-228558, 11-246510, 11-246540, 11-246541, 11-322735, 2000-1482, 2000-26546, 2000-191652, 2000-302774, 2000-336133, 2001-31664, 2001-31665, 2001-31666, 2001-163882, 2001-226365, 2001-278874, 2001-278875, 2001-302651, 2001-342194, 2002-20376, 2002-80581, 2002-193965, 2002-341489, 2002-75171, 2002-275172, 2002-322268, 2003-2881, 2003-12662, and 2003-81958, and Japanese Patent Publication Open to Public Inspection (under PCT Application) No. 11-500422. These compounds may be employed individually or in combinations of at least two types.

Incidentally, for the purpose of controlling the liquid viscosity of the resulting compositions as well as the physical properties of the resulting binder matrix, binder compound (A) having a reactive group capable of achieving cationic polymerization may be used together with binder compounds having an epoxy group, a vinyl ether group, an alkenyl ether group, an allene ether group, or a ketene acetal group, other than compounds having an oxetane group. The amount of binder compound (A) having a reactive group capable of achieving cationic polymerization is customarily 5 - 95 percent by weight with respect to the holographic recording compositions, and is preferably 10 - 90 percent by weight.

When the aforesaid photopolymerization initiators do not, or only barely, absorb a laser beam having a wavelength which is used for the holographic exposure described below, in order to spectrally sensitize the photopolymerization initiators, it is more preferable to simultaneously use spectral sensitizing dyes.

The polymerizing compound (B) having an ethylenic double bond in the molecule employed in the present invention is not specifically limited if it does not prevent the effects of the present invention.

By considering adhesion with the substrate and compatibility with a binder compound (A) at the time of being formed into a recording medium, the polymerizing compound (B) is preferably a compound having an acyloxy group or an acylamino group in the molecule.

And further, by considering steric hindrance at the time of performing radical polymerization, more preferable is a compound having a (meth)acryloyl group. Herein, a meth(acryloyl) group referred in the present invention represents an acryloyl group or a methacryloyl group.

Such compounds having a (meth)acryloyl group include, for example, phenol, nonylphenol, and (meth)acrylate or (meth)acrylamide of 2-ethylhexanol, in addition to (meth)acrylate or (meth)acrylamide of the alkyleneoxide adducts of these alcohols, as compounds having one (metha)acryloyl group. Listed are bisphenol A, isocyanulic acid and di(meth)acrylate or di(meth)acrylamide of fluorene, in addition to di(meth)acrylate or di(meth)acrylamide of the alkyleneoxide adducts of these alcohols, and di(meth)acrylate or di(meth)acrylamide of polyalkyleneglycols such as ethyleneglycol and propyleneglycol, as compounds having two (metha)acryloyl groups. Listed are pentaerythritol, trimethylolpropane and tri(meth)acrylate or tri(meth)acrylamide of isocyanuric acid, in addition to tri(meth)acrylate or tri(meth)acrylamide of the alkyleneoxide adducts of these alcohols, as compounds having three (metha)acryloyl groups; and poly(meth)acrylate or poly(meth)acrylamide of pentaerythritol and dipentaerythritol as compounds having four or more (metha)acryloyl groups. Further, acryl- or acrylamide-type monomer and/or oligomer conventionally known such as urethane acrylate having a urethane bond as the main chain, polyester acrylate having an ester bond as the main chain, and epoxy(meth)acrylate in which an acrylic acid is added to an epoxy compound are also appropriately selected to be utilized in the present invention.

Herein, the compounds having plural (meth)acryloyl groups may be provided with (meth)acrylate alone or (meth)acrylamide alone, or may be provided with (meth)acrylate and (meth)acrylamide.

To provide the polymer obtained by diffusion polymerization of polymerizing compound (B) having an ethylenic double bond a significant refractive index difference against the binder matrix formed from the cross-linking agent (D) having a functional group capable of reacting with said reactive group of the aforesaid binder compound (A) having a reactive group, it is preferable to employ said polymerizing compound having a higher refractive index or a lower refractive index compared to those of the binder compound (A) and/or the cross-linking agent (D). Specifically, it is preferable to employ the binder compound (A) and/or the cross-linking agent (D) having a refractive index of at least 1.55 in the case of employing a compound having a refractive index of around 1.50 as the binder compound (A) and/or the cross-linking agent (D), with respect to obtaining a polymer of a polymerizing compound (B) having a high refractive index.

Herein, these polymerizing compounds (B) having an ethylenic double bond in the molecule may be utilized alone or in combination of two or more types, and they are generally contained at 5 -95 weight% and preferably at 20 - 90 weight% in the holographic recording composition.

Further, the photo-polymerization initiator (C) is detailed.

The photo-polymerization initiator (C) used in the present invention and is selected from commonly known carbonyl compounds such as benzoin and derivatives thereof and benzophenone, azo compounds such as azobisisobutylonitrile, sulfur compounds such as dibenzothiazolylsulfide, peroxide compounds such as benzoyl peroxide, halogen compounds such as 2-tribromomethanesulfonyl pyridine, onium compounds such as an iodonium salt and a sulfonium salt, metal $\pi$ complexes such as an iron allen complex and a titanocene complex.

It is preferred to employ a sensitizing dye with the photo-polymerization initiator, when the photoinitiator absorbs only small amount of a laser light or does not absorb a laser light employed for holographic exposure. The sensitizing dye enables spectral sensitization of the photoinitiator.

Incidentally, listed as spectral sensitizing dyes which are employed to spectrally sensitize photopolymerization initiators used herein may be various dyes which are used in this field. Examples include coumarin derivatives, methine derivatives, polymethine derivatives, triarylmethane derivatives, indoline derivatives, azine derivatives, thiazine derivatives, xanthene derivatives, thioxanthene derivatives, oxazine derivatives, acridine derivatives, cyanine derivatives, carbocyanine derivatives, merocyanine derivatives, hemicyanine derivatives, rhodacyanine derivatives, azomethine derivatives, styryl derivatives, pyrylium derivatives, thiopyrylium derivatives, porphyrazine derivatives, porphyrin derivatives, phthalocyanine derivatives, and pyrromethene derivatives. These dyes may be employed individually or in combinations of at least two types.

Specific examples of such photopolymerization initiators and sensitizing dyes include those described, for example, in U.S. Patent Nos. 5,027,436, 5,096,790, 5,147,758, 5,204,467, 5,256,520, and 6,011,180; European Patent Nos. 255,486, 256,981, 277,915, 318,893, 401,165, and 565,486; and JP-A Nos. 2-236553, 5-46061, 5-216227, 5-247110, 5-257279, 6-175554, 6-175562, 6-175563, 6-175566, 6-186899, 6-195015, 6-202540, 6-202541, 6-202543, 6-202544, 6-202548, 6-324615, 6-329654, 7-13473, 7-28379, 7-84502, 7-84503, 7-181876, 9-106069, 9-309907, 2002-60429, 2002-62786, and 2002-244535. The aforesaid compounds may be selected as appropriate, and then employed.

Further, it is also possible to use as suitable the photopolymerization initiators represented by Formula (3) below. Compared to an radical photopolymerization initiator system in which spectral sensitizing dyes are combined

with the radical photopolymerization initiators so that the aforesaid initiators are spectrally sensitized for the wavelength of the exposure light source, the aforesaid photopolymerization initiators are capable of efficiently generating radicals since the boron anion portion which generates radicals exists near the cationic dyes used as a spectral sensitizing dye. At the same time, by changing the structure of the cationic dyes, it is possible to readily match the resulting spectral sensitization to the wavelength of the light source used for holographic exposure.

Formula (3)

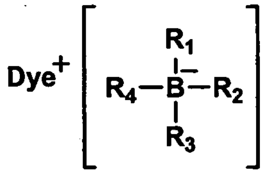

wherein $Dye^+$ is a cationic dye, each $R_1$ to $R_4$ is independently a substituted or unsubstituted alkyl, aryl, aralkyl, alkenyl, alkynyl, heterocylic group, or a cyano group, provided that two or more of $R_1$ to $R_4$ can form a ring by binding together.

Herein, in order to generate radicals efficiently, in the compounds represented by Formula (3), at least one of the substituents represented by $R_1$ - $R_4$ of the boric anion portion is preferably a substituted or non-substituted alkyl group, aralkyl group, alkenyl group or alkynyl group, and the others are any of substituted or non-substituted aryl groups and heterocyclic groups.

Further, as the cationic dyes represented by $Dye^+$ in the compounds represented by Formula (3), cationic dyes conventionally utilized in various applications can be suitable selected. Preferable examples are, methine dyes, polymethine dyes, triarylmethane dyes, indoline dyes, azine dyes, thiazine dyes, xanthene dyes, oxazine dyes, acridine dyes, cyanine dyes, carbocyanine dyes, hemicyanine dyes, rhodacyanine dyes, azamethine dyes, styryl dyes, pyrylium dyes, thiopyrylium dyes and coordination metal complexes represented by following Formula (4).

Formula (4) $M^{a+}(L)_b$

wherein M represents a metal atom, "a" represents an integer of 1 - 4, L represents a ligand and "b" represents an integer of 1 - 6.

Further, a ligand represented by L in Formula (4) is preferably a dye capable of chelating having at least 2 coordination number against a metal ion. This is preferable because of the stability of the coordination metal complex, as well as of easy adjustment of maximum spectral wavelength in the case of the wavelength of the light source for holographic exposure having 500 nm or longer.

Examples of dyes capable of chelating with a coordination number 2 or more are as follows.

L-1

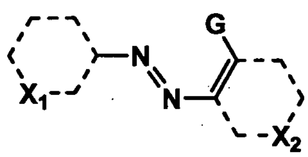

L-2

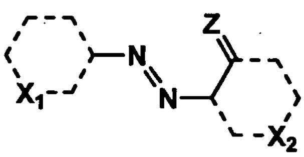

L-3

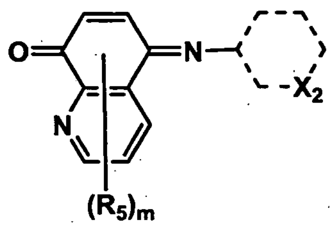

L-4

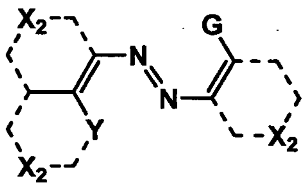

L-5

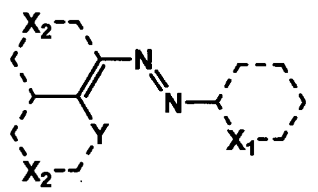

L-6

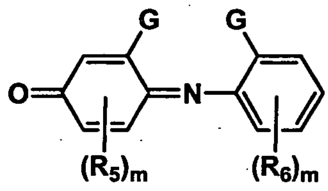

L-7

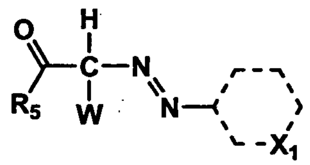

L-8

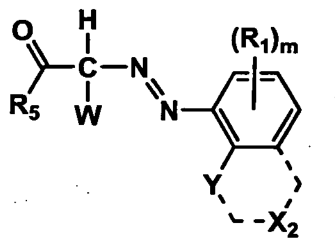

L-9

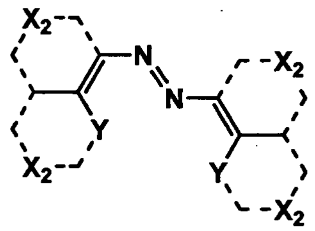

wherein, $X_1$ represents an atomic group necessary to complete an aromatic carbon ring or a heterocyclic ring in which at least one of the adjacent positions to the carbon bonding to an azo bond is substituted by a nitrogen, oxygen, sulfur, selenium or tellurium atom and at least one ring is comprised of 5 - 7 atoms, and $X_2$ represents an atomic group necessary to complete a carbon ring or a heterocyclic ring, wherein each of a carbon ring and a heterocyclic ring may be substituted. G represents a chelating group, W represents - $COR_7$ or -$CSR_7$, Y represents -O-, -S-, -N=, -NH- or -$NR_8$-, Z represents O or S, and m and n represent integers of 1 - 5. $R_1$ and $R_2$ represent a hydrogen atom, a halogen atom, a cyano group, an alkyl group, an alkenyl group, an alkoxy group, an alkylsulfonamide group, an arylsulfonamide group, an anilino group, an acylamino group, an alkylureido group, an arylureido group, an alkoxycarbonyl group, an alkoxycarbonyl amino group, a carbamoyl group, a sulfamoyl group, a sulfo group, a carboxy group, an aryl group or a heterocyclic group. $R_7$ represents a hydrogen atom, an alkyl group, an alkenyl group, an alkoxy group, an alkylsulfonamide group, an arylsulfonamide group, an anilino group, an acylamino group, an alkylureido group, an arylureido group, a carbamoyl group, a sulfamoyl group, a sulfo group, an aryl group or a heterocyclic group; and $R_8$ represents an alkyl group, an alkenyl group, an aryl group or a heterocyclic group.

Further, metal ions represented by $M^{a+}$ in aforesaid Formula (2) include such as silver (I), aluminum (III), gold (III), cerium (III, IV), cobalt (II, III), chromium (III), copper (I, II), europium (III), iron (II, III), gallium (III), germanium (IV), indium (III), lanthanum (III), manganese (II), nickel (II), palladium (II), platinum (II, IV), rhodium (II, III), ruthenium (II, III, IV), scandium (III), silica (IV), samarium (III), titanium (IV), uranium (IV), zinc (II) and zirconium (IV); preferable among them are tetra- or hexa-dentately coordinating metal ions in case of bidentate coordinating dyes, and preferable are hexa-dentately coordinating metal ions in case of tridentate coordinating dyes. Specifically preferable metal ions can include zinc (II), nickel (II), cobalt (II, III), copper (II), rhodium (II, III), ruthenium (II, III), palladium (II) and platinum (II, IV).

Each "bidentate", "tridentate" and "tetradentate" and "hexa-dentate" means a coordination number 2, 3, 4 and 6 respectively.

Photopolymerization initiators used in the holographic recording method, which stabilizes information recorded by exposing the entire holographic recording media, detailed below, to heat and light, generate active species capable of undergoing radical polymerization. Of these, any ones which generate active species which initiate cationic polymerization are preferred. The used amount of the aforesaid photopolymerization initiators varies depending on the molecular weight of photopolymerization initiator (C) and the ratio of the ethylenic double bond in polymerizable compound (B) having an ethylenic double bond and may not be definitely decided. However, it is preferable to generally use them in the range of 0.01 - 25 parts by weight with respect to polymerizable compound (B), having an ethylenic double bond.

Further, in the present invention, other than the aforesaid indispensable components, utilized by appropriate selection may be such as reaction accelerators for the purpose of accelerating the reaction of a binder compound (A) having a reactive group and a cross-linking agent (D) having a functional group capable of reacting with a reactive group of a binder compound (A), thermal expanding agents for the purpose of preventing thermal shrinkage after recording, thermal polymerization inhibitors to prevent thermal polymerization at the time of preparation of the recording composition, and plasticizers or thermally-fusing compounds to control the liquid viscosity at the time of preparation of the recording composition.

Acid multiplying agents usable in the present invention refer to compounds which are substituted with the residual group of a relatively strong acid and relatively readily undergo elimination reaction to generate acid. Consequently, it is possible to markedly activate the aforesaid elimination reaction utilizing a catalytic acid reaction. In the absence of acid, acid multiplying agents are stable, while in the presence of acid, it becomes possible to easily generate acid via a thermal reaction. By combining acid multiplying agents exhibiting such properties with thermal cationic polymerization initiators in a holographic recording composition comprising a proton donating functional group such as a hydroxyl group, it is possible to markedly enhance the acid generating efficiency due to the presence of acid which is slightly formed by the reaction of the thermal cationic polymerization initiators with the compounds having a proton donating functional group. Consequently, acid is repeatedly generated via decomposition due to the catalytic reaction, so that at least one acid increases via one frequency of the reaction, whereby acid production is increased geometrically. Incidentally, in order to induce the self-decomposition of generated acids themselves, the strength of acids generated herein is preferably at most 3 in terms of the acid dissociation constant (pKa) and more preferably at most 2. Acids which are weaker than this are not preferred since they rarely undergo self-decomposition. Listed as such acids may be, for example, dichloroacetic acid, trichloroacetic acid, methanesulfonic acid, trifluoromethanesulfonic acid, ethanesulfonic acid, benzenesulfonic acid, p-toluenesulfonic acid, naphthalenesulfonic acid, and triphenylphosphonic acid.

Listed as specific acid multiplying agents may be, for example, the compounds described in JP-A Nos. 8-248561, 9-34106, 10-1508, 11-102066, 11-180048, 2000-34272, 2000-35665, 2000-119557, 20001-22069, 2001-48905, 2001-81138, 2001-83658, 2001-117196, and 2001-323178. The aforesaid acid multiplying agents may be employed individually or in combinations of at least two types.

Further, inflating agents refer to compounds in which bonds in inflating agents are broken due to heat to form a plurality of compounds. Listed as specific examples of such inflating agents may be the compounds described in U.S. Patent Nos. 6,124,076 and 6,221,536. Further, the aforesaid thermal cationic polymerization initiators and acid multiplying agents, when decomposed, are subjected to bond breakage to form a plurality of molecules, whereby they also exhibit a function as an inflating agent.

Still further, if desired, thermal polymerization inhibitors, plasticizers, and heat fusible compounds may be selected from among the conventional compounds known in the art, and then employed.

Next, a holographic recording medium of the present invention will be detailed.

A holographic recording medium of the present invention is characterized in that a holographic recording layer is sandwiched between the first and second substrates and said holographic recording layer contains: a binder compound (A) having a reactive group which can be cationic polymerized, a polymerizable compound (B) having an ethylenic double bond, a photo-polymerization initiator(C), and a cross-linking agent (D) which can react with the binder compound (A).

The cross-linking agent (D) is a thermo cationic polymerization initiator.

Herein, a binder compound (A) having a reactive group, a polymerizing compound (B) having an ethylenic double bond in the molecule, a photo-polymerization initiator (C), a cross-linking agent (D) having a functional group capable of reacting with the reactive group of said binder compound (A) having a reactive group, and a compound presented by Formula (1) which is at least contained in a recording layer as said photo-polymerizing initiator (C) have the same definitions as detailed in the aforesaid holographic recording composition.

Next the first and second substrates constituting a recording medium will be explained. Herein, the first substrate is a substrate on the incident side of information light and reference light at the time of holographic exposure for information recording or a substrate on the irradiation side of reproduction light for reproduction, and the second substrate is a substrate on the opposite to said first substrate sandwiching a holographic recording layer.

As the first and second substrates employed in a recording medium of the present invention, utilized without specific restriction can be those being transparent and causing no shrinkage nor bending under using ambient temperatures, as well as inactive against the aforesaid recording composition. Listed examples of such substrates are glasses such as quartz glass, soda glass, potash glass, lead crystal glass, boric silicate glass, aluminum silicate glass, titanium crystal glass and crystallized glass, and various types of resins such as polycarbonate, polyacetal, polyallylate, polyetheretherketone, polysulfon, polyethersulfon, polyimides such as polyimidoamide and polyetherimide, polyamide and polyolefins such as cyclic olefin-type open chain polymerization products.

Among the aforesaid substrates, glass is preferred as the first substrate which is at the incident side of information light and reference light, in view of thickness variation due to ambient temperature and humidity or gas permeability at the time of holographic exposure as well as transmittance of light at the wavelength of the light source employed for holographic exposure. Further, glass is preferred as the second substrate similarly to the first substrate. Further, substrates comprising resin may be utilized instead of glass, in which shrinkage rate or thickness variation is restrained, when a device equipped with a focus compensation mechanism at the time of reading out the holographic recorded information by use of CCD.

Further, the light transmittance of incident light over the first substrate which is on the incident side of information light and reference light is at least 70% and more preferably at least 80%, with respect to minimizing the loss of light reaching to a holographic recording layer. To increase the transmittance as much as possible, the substrate plane opposite to the surface, on which a holographic recording layer is accumulated, is preferably subjected to an anti-reflection treatment. As anti-reflection treatment, there is no specific restriction as far as the refractive index is lower than that of the first substrate. Preferable are, for example, inorganic metallic fluorides such as $ALF_3$, $MgF_2$, $ALF_3{\cdot}MgF_2$ and $CaF_2$; homopolymers, copolymers, graft polymers and block polymers containing a fluorine atom such as vinylidenefluoride and Teflon™; and organic fluorides such as modified polymers modified by a functional group containing a fluorine atom; with respect to achieving a lower refractive index of a substrate than those detailed above.

Further, methods to provide a layer comprising a compound of a fluoride type on the substrate, are not indiscriminately determined depending on the types of the support and the fluoride type compound. Commonly known methods can be employed, such as a sol-gel method, a vacuum evaporation method, a sputtering method, a CVD method and a coating method, or methods described in JP-A Nos. 7-27902, 2001-123264 and 2001-264509, by appropriate selection.

The thickness of an anti-reflection layer cannot be uniquely defined depending on surface treatments and materials. The thickness of an anti-reflection layer is generally in a range of 0.001 - 20 μm and preferably in a range of 0.005 - 10 μm.

Further, a reflecting layer is preferably provided on the surface of the second substrate on which a holographic recording layer is accumulated or on the opposite surface of a recording medium employed in a holographic recording and/or reproducing device of such as JP-A No. 2002-123949 and World Patent No. 99/57719. The reflectance is preferably at least 70% and more preferably at least 80% against the wavelength of the reflecting light when a reflecting layer is provided.

The materials for a reflective layer is not specifically restricted under the condition that they produce a desired reflectance. A reflective layer can be obtained by accumulating a thin metallic layer on the substrate surface. For example, to form such a reflective layer, a metallic thin layer is provided as a single crystal or a multi-crystal by means of commonly known methods such as a vacuum evaporation method, an ion plating method and a sputtering method; and employed can be metals alone or in combination of two or more kinds selecting from such as aluminum, zinc, antimony, indium, selenium, tin, tantalum, chromium, lead, gold, silver, platinum, nickel, niobium, germanium, silica, molybdenum, manganese, tungsten and palladium. The thickness of the metallic thin layer is not specifically limited under the condition that they produce a desired reflectance. It is generally in a range of 1 - 3000 nm and preferably it is in a range of 5 - 2000 nm.

On the other hand, in a holographic recording medium, prepared can be a recording medium having a large memory capacity by making a holographic recording layer thick as much as possible. However, in the present invention, it is preferable to satisfy the relationship of $0.15 \leq Dh/(d1 + d2) \leq 2.0$ when the thickness of the first substrate is d1, that of the second substrate is d2 and that of a holographic recording layer is Dh, with respect to the utilizing environment of said recording medium or errors at reading recorded information.

Herein, the thickness of a holographic recording layer cannot be made thick when $0.15 > Dh/(d1 + d2)$, or the thickness of the substrate becomes thick resulting in making the total thickness of a recording medium thick even when the thickness of the recording layer is made thick. In this case, it is not preferable that the weight of a recording medium itself becomes heavy which may result in causing a burden onto the driving system of the apparatus. While, when $Dh/(d1 + d2) > 2.0$, it is possible to make the thickness of a recording medium thinner keeping the thickness of the recording layer. However, it is not preferable that the thickness of the recording layer becomes thicker compared to that of the substrate which may result in poor plane precision of the recording medium and uneven thickness of the recording layer under using ambient temperature, in addition to thickness variation of the recording layer and slippage between the first and second substrates in case of receiving unexpected stress.

Further, the relationship between the thickness of the first substrate d1 and the thickness of the second substrate d2 preferably satisfies, $d1 \leq d2$, by considering energy loss at the time of holographic exposure, and the thickness ratio of d1 and d2 is more preferably in a range of $0.20 \leq d1/d2 \leq 1.00$ to maintain the flatness of the recording medium.

Further, the thickness of a holographic recording layer Dh cannot be indiscriminately determined depending on such as a diffraction efficiency, a dynamic range and a spatial resolution. However, the thickness is preferably at least 200 μm and at most 2.0 mm. A recording medium having a high memory capacity is hardly obtained when it is

less than 200μ m. When it is more than 2.0 mm, it may result in poor plane precision of the recording medium and uneven thickness of the recording layer under using ambient temperature.

The shape of a recording medium is not specifically limited under the condition that it is suitable for holographic recording and/or reproducing devices. However, a disc shape is preferred, if the recording medium is used in the devices described in such as USP No. 5,719,691 and JP-A No. 2002-123949. A card shape is preferred if the recording medium is used in the devices described in such as WO 99/57719.

As a method to prepare the recording media detailed above, a holographic recording layer forming composition is prepared by mixing the holographic recording composition under safelight at ordinary temperature or appropriately being heated; the holographic recording composition kept at ordinary temperature or appropriately being heated is applied on the first substrate after being degassed to depress polymerization inhibition at the time of holographic exposure; successively after laminating the second substrate without introducing any foams so as to make the predetermined thickness; the resulting system is finally sealed at the edges to produce a recording medium. Further, a recording medium can be produced by fixing the first and second substrate in a form to keep a predetermined interval under safe light, followed by injection molding a holographic recording composition at ordinary temperature or appropriately being heated without introducing any foams, or filling the composition between the first and second substrates by means of suction with reduced pressure not as to introduce any foams, and finally sealing the edges. Herein, "under safe light" indicates operation under the state where the wavelengths of the light to activate photo-polymerization initiator and those to be employed in the case of utilizing light to form the binder matrix are shielded.

Further, in the case of preparing a recording medium by means of lamination, a holographic recording layer forming composition may be applied also on the second substrate instead of on the first substrate as described above, or on the both of the first and second substrates. In addition to this, to seal the edges of the first substrate, a holographic recording layer and the second substrate, sealing may be performed by cross-linking a sealing material of a liquid state capable of sealing or by employing a sealing material of a ring-shape to make the predetermined thickness.

Next, a method to record information on a holographic recording medium will be detailed.

The first embodiment according to holographic recording methods of the present invention is characterized in that a holographic recording layer is sandwiched between the first and second substrates, said holographic recording layer including a binder compound (A) having a reactive group which is cationic polymerizable, a polymerizing compound (B) having an ethylenic double bond in the molecule, a photo-polymerization initiator (C) and a cross-linking agent (D) having a functional group reactive with the reactive group of the binder compound (A) having a reactive group. The cross-linking agent (D) is capable of starting cationic polymerization after being subjected to heat.

The holographic recording method is performed,(i) by cross-linking a binder compound (A) with a cross-linking agent (D) with heat prior to holographic exposure; (ii) activating the photo-polymerization initiator (C) with a holographic exposure based on the information to be recorded; and (iii) diffusion polymerizing a polymerizing compound (B) having an ethylenic double bond in the molecule to achieve recording information to the holographic recording media.

In the case of a heavy thickness layer is applied, since the recording layer forming composition is prepared generally without a solvent for dilution, it becomes difficult with a solid or highly viscous composition to obtain a uniform layer thickness or to eliminate foams involved at the time of preparing the composition.

Therefore, the recording layer forming composition is necessary to have a fluid property in a state at ordinary temperature or being heated when it has been prepared. Specifically, in the case that the recording layer forming composition is liquid and has a low viscosity at ordinary temperature, it is not preferable that the flatness as a recording medium may be hardly retained, or the polymers formed by diffusion polymerization of a polymerizing compound (B) may possibly be dislocated in a recording layer after information having been recorded by holographic exposure.

Therefore, in the holographic recording medium containing the aforesaid indispensable components, it is possible to ensure the flatness and prevent migration of the polymer formed by diffusion polymerization of a polymerizing compound (B) in the recording layer by cross-linking a binder compound (A) having a reactive group and a cross-linking agent (D) having a functional group with heat or light irradiation which cannot activate the photo-polymerizing initiator (C) before holographic exposure to form a binder matrix.

In this way, it is possible to record information on a holographic recording medium by performing holographic exposure based on information to be recorded after a binder matrix having been formed, and activating a photo-polymerization initiator (C) to perform diffusion polymerization of a polymerizing compound (B) having an ethylenic double bond in the molecule by this active species.

Herein, in a cross-linking reaction to form a binder matrix of this recording method, all of the binder compound (A) having a reactive group and cross-linking agent (D) having a functional group or only a part of them within a range of not causing practical troubles may be subjected to reaction. Further, to fix holographic information recorded after finishing information recording on a holographic recording medium, it is preferable to complete polymerization, with light and heat appropriately applied, of the residual binder compound (A) having a reactive group and cross-linking agent (D) having a functional group in addition to polymerizing compound (B) having an ethylenic double bond in the molecule. In this case, light employed for the exposure is preferably exposed at once (hereafter, it is called as sum exposure) over

the whole recording medium.

Further, it is not possible to definitely decide conditions in which binder compound (A) having a reactive group capable of achieving cationic polymerization, which activates thermal cationic polymerization initiators while heated, is subjected to undergo thermal crosslinking, since they vary depending on the types and ratio of used thermal cationic polymerization initiators and binder compounds having a reactive group capable of achieving cationic polymerization. However, the heating temperature is customarily 30 - 180 °C, and is preferably 40 - 150 °C. Further, it is preferable that thermal processing time, when processed at equal to or higher than 100 °C, is 0.1 second - 2 hours, when processed at 50 - 100 °C, it is 1 minute to 1 week, and when processed at lower than 50 °C, it is 1 hour - 1 month.

The second embodiment according to holographic recording methods of the present invention is characterized in that a holographic recording layer is sandwiched between the first and second substrates, said holographic recording layer containing a binder compound (A) having a reactive group, a polymerizing compound (B) having an ethylenic double bond in the molecule, a photo-polymerization initiator (C) and a cross-linking agent (D) having a functional group reactive with the reactive group of the binder compound (A) having a reactive group.

The holographic recording method is performed on the holographic recording medium, wherein after performing holographic exposure based on information to be recorded to activate a photo-polymerization initiator (C), information is recorded on the holographic recording medium by diffusion polymerization of a polymerizing compound (B) having an ethylenic double bond in the molecule with this active species, and further heat and light is given to all over the holographic recording medium after finishing information recording on the holographic recording medium to stabilize the recorded information.

This embodiment, different from the aforesaid first embodiment, is a recording method effective for holographic recording media the recording layer of which is comprised of a recording layer forming composition which flows in a state of being heated while does not flow at ordinary temperature, or a recording layer forming composition which is gelled at ordinary temperature as far as shearing stress is not applied and having a thixotropic property, when the recording layer forming composition has been prepared.

In such recording media, it is possible to achieve the level causing no problem in practical application with respect to ensuring the flatness of said recording media and preventing migration of the polymer formed by diffusion polymerization of a polymerizing compound (B), however it is preferable to complete polymerization, with light and heat appropriately applied, of the residual binder compound (A) having a reactive group, cross-linking agent (D) having a functional group and polymerizing compound (B) having an ethylenic double bond in the molecule after information has been recorded on the holographic recording media for the purpose of fixing the recorded holographic information, wherein, light employed for the exposure is preferably exposed at once (sum exposure) over the whole recording medium.

When the recording media is heated, heat can be applied either (i) prior to sum exposure; (ii) at the same time as sum exposure; or (iii) after sum exposure. Any combination of heating of (i) to (iii) can be chosen.

Further, as apparatuses for recording and reproducing of a holographic recording media according to the first and the second embodiments of the present invention, employed can be any of those proposed provided that being capable of recording and reproducing with the recording media of the present invention. Listed examples of such methods and apparatuses for recording and reproducing are those described in, for example, in USP Nos. 5,719,691, 5,838,467, 6,163,391, 6,414,296, US Patent Publication Open to Public Inspection No. 2002-136143, JP-A Nos. 9-305978, 10-124872, 11-219540, 2000-98862, 2000-298837, 2001-23169, 2002-83431, 2002-123949, 2002-123948, 2003-43904, World Patent Nos. 99/57719, 02/05270 and 02/75727.

Laser light sources employed in the aforesaid methods and apparatuses for recording and reproducing are not specifically limited, provided that they can record holographic record information by activating a photo-polymerization activator in the recording medium and to read out the recorded hologram, and include such as a semiconductor laser of a blue light region, an argon laser, a He-Cd laser, a YAG laser of a double frequency, a He-Ne laser, a Kr laser and a semiconductor laser of a near infrared region.

## EXAMPLES

The present invention will be specifically explained in reference to the following examples. However, embodiments of the present invention are not limited thereto.

Incidentally, shown below are binder compounds (A-1 - 9) having a reactive group capable of achieving cationic polymerization, polymerizable compounds (B-1 - 8) having an ethylenic double bond, photopolymerization initiators (C-1 - 4), spectral sensitizing dyes (S-1 - 2), thermal cationic polymerization initiators (D-1 - 8), and acid multiplying agents (Z-1- 2), which were employed to prepare holographic recording layer compositions.

<Binder Compounds Having a Reactive group Capable of Achieving Cationic Polymerization>

(A-1) polypropylene glycol diglycidyl ether (Epolight 200P, manufactured by Kyoeisha Chemical Co., Ltd.)
(A-2) trimethylolpropane triglycidyl ether
(A-3) Bisphenol A type epoxy resin (Epototo YD127, manufactured by Toto Kasei Co., Ltd.)
(A-4) 1,8-bis{(3-ethyloxetane-3-il)methoxy}-2,7-dihydroxyoctane
(A-5) di[1-ethyl(3-oxetanyl)]methyl ether
(A-6) 2-oxaspiro[3,5]-5-methylnonane

A-7

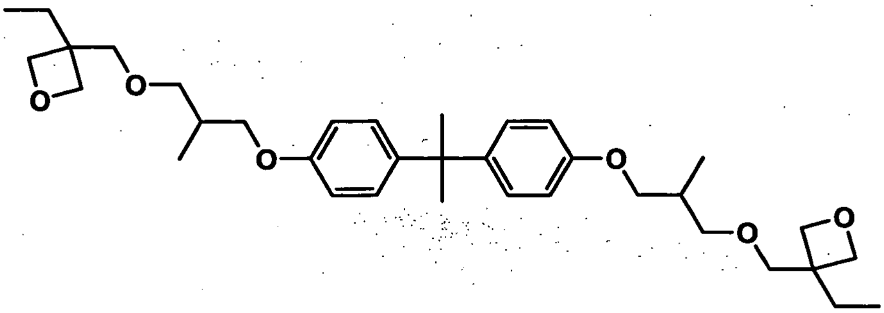

A-8

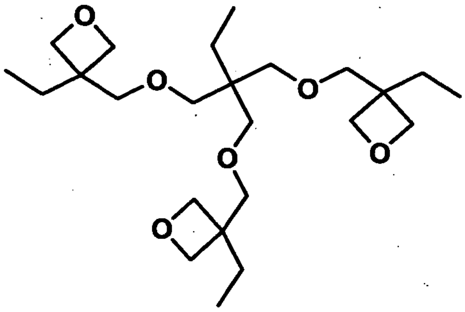

A-9

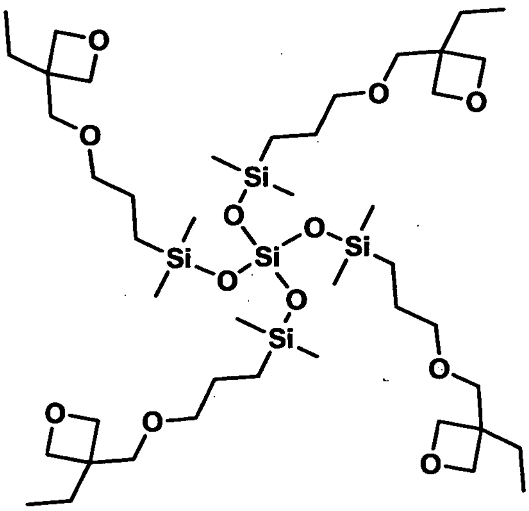

(A-10) 3-ethyl-3-hydroxymethyloxetane
(A-11) 3-ethyl-3-(phenoxymethyl)oxetane
(A-12) 3-ethyl-3-(2-hetylhexycyloxymethyl)oxetane

<Polymerizable Compounds Having an Ethylenic Double Bond>

(B-1) 4-bromostyrene (at a refractive index of 1.594)
(B-2) 4-chlorophenyl acrylate (at a refractive index of 1.536)
(B-3) p-cumylphenoxyethylene glycol acrylate (at a refractive index of 1.548, NK Ester A-CMP-1E, manufactured by Shin-Nakamura Chemical Co., Ltd.)
(B-4) hydroxyethylated β-naphthol acrylate (at a refractive index of 1.583, NK Ester A-NP-1E, manufactured by Shin-Nakamura Chemical Co., Ltd.)
(B-5) tribromophenyl acrylate (at a refractive index*1 of 1.567)
(B-6) tribromophenyl methacrylate (at a refractive index*1 of 1.560)
(B-7) EO-modified tribromophenyl acrylate (at a refractive index*1 of 1.564, New Frontier BR-31, manufactured by Dai-ichi Kogyo Seiyaku Co., Ltd.)
(B-8) EO-modified tetrabromobisphenol A dimethacrylate (at a refractive index*1 of 1.564, New Frontier BR-42M, manufactured by Dai-ichi Kogyo Seiyaku Co., Ltd.)

Refractive index*1 is a value determined at 25 °C to make a 50 percent styrene solution.

<Photopolymerization Initiators, Spectral Sensitizing Dyes, Thermal Cationic Polymerization Initiators, and Acid Multiplying Agents>

The aforesaid compounds are shown below.

C-1

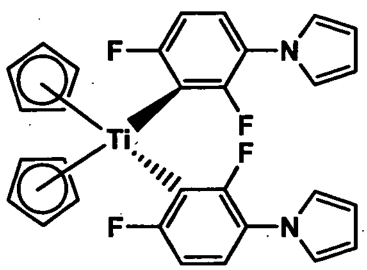

C-2

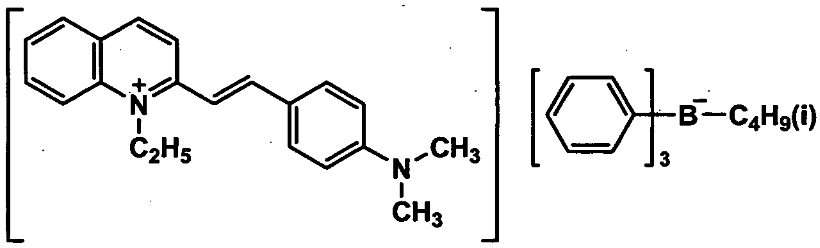

C-3

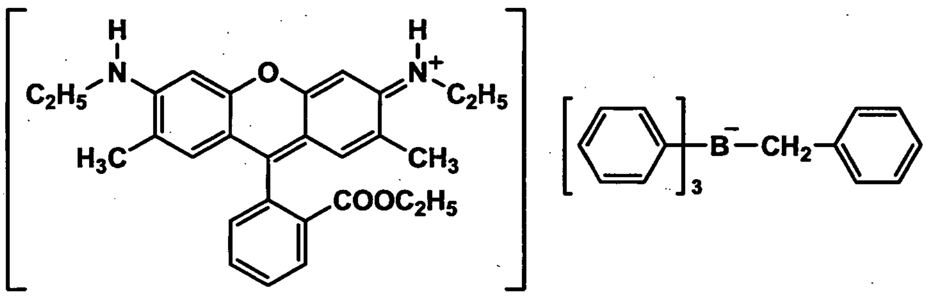

C-4

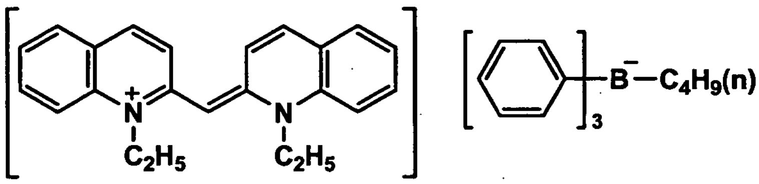

C-5

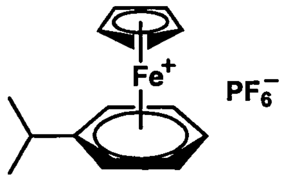

S-1

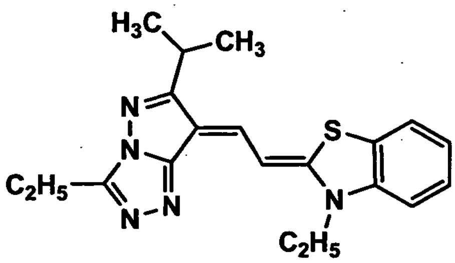

S-2

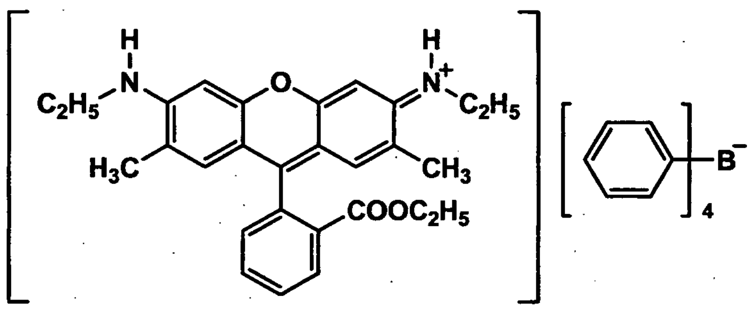

S-3

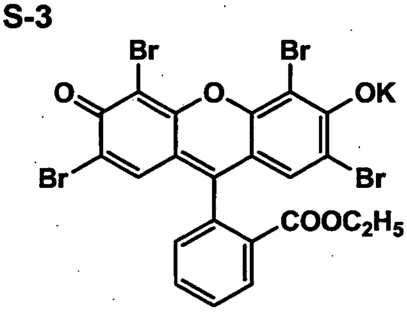

S-4

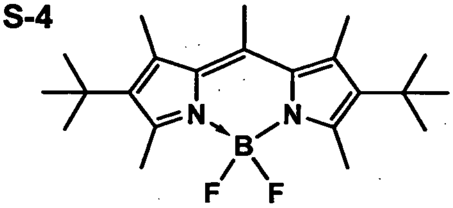

S-5

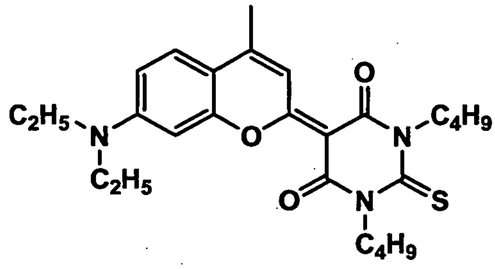

Z-1

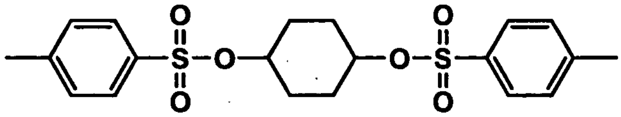

Z-2

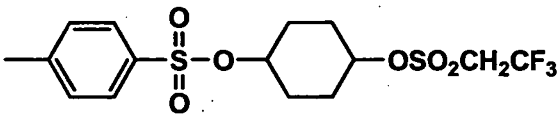

D-1

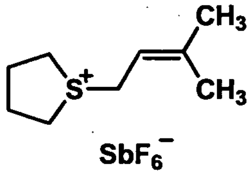

D-2

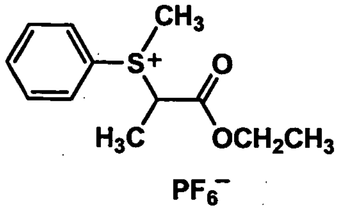

D-3

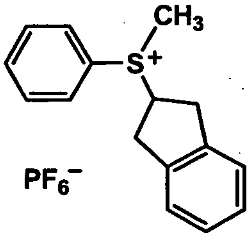

D-4

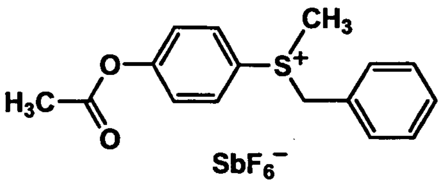

D-5

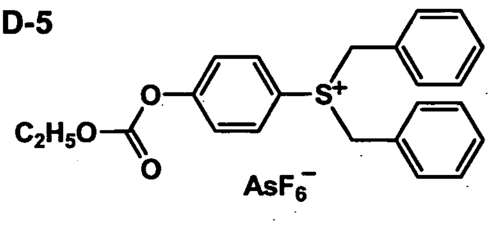

D-6

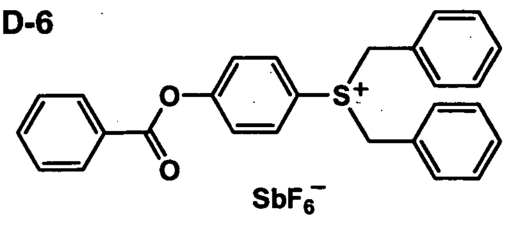

D-7

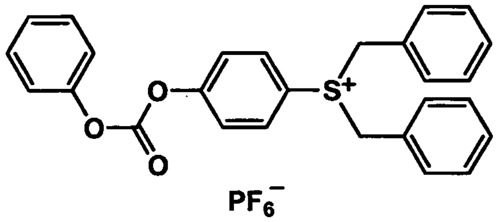

D-8

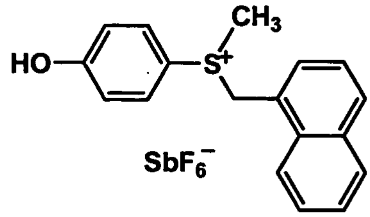

«Preparation of Holographic Recording Layer Forming Compositions»

(Holographic Recording Layer Forming Composition 1)

Solution 1 was prepared by mixing 9.697 g of Binder Compound (A-1) having a reactive group capable of achieving cationic polymerization, 6.042 g of pentaerythritol (tetrakismercaptopropionate) as a crosslinking agent, and 0.840 g of 2,4,6-tris(dimethylaminomethyl)phenol as a crosslinking accelerator. Separately prepared Initiator Solution 1 which comprised 2.194 g of Polymerizable Compound (B-2) having an ethylenic double bond, 0.126 g of Photopolymerization Initiator (C-1), and 0.00126 g of Spectral Sensitizing Dye (S-1) was added to aforesaid Solution 1. After deaerating the resulting composition employing nitrogen, included gaseous components were finally removed by vacuum degassing, whereby Comparative Holographic Recording Layer Forming Composition 1 was prepared.

(Holographic Recording Layer Forming Composition 2)

Solution 2 was prepared by mixing 9.697 g of Binder Compound (A-1) having a reactive group capable of achieving cationic polymerization, 6.042 g of pentaerythritol(tetrakismercaptopropionate) as a crosslinking agent, and 0.840 g of 2,4,6-tris(dimethylaminomethyl)phenol as a crosslinking accelerator. Separately prepared Initiator Solution 2 which comprised 0.878 g of Polymerizable Compound (B-1) having an ethylenic double bond, 1.313 g of (B-2), 0.126 g of Photopolymerization Initiator (C-1), and 0.00126 g of Sensitizing Dye (S-1) was added to aforesaid Solution 2. After de-aerating the resulting composition employing nitrogen, included gaseous components were finally removed by vacuum degassing, whereby Comparative Holographic Recording Layer Forming Composition 2 was prepared.

(Holographic Recording Layer Forming Compositions 3 - 6)

Solution 3 was prepared by mixing 7.870 g of (A-1), 4.722 g of (A-2), and 3.148 g of (A-5) as a binder compound. Separately, Photopolymerization Initiator Solution 3 was prepared by mixing and dissolving 0.878 g of (B-1), 1.313 g of (B-2) as a polymerizable compound having an ethylenic double bond, 0.126 g of Photopolymerization Initiator (C-1), and 0.00126 g of Sensitizing Dye (S-2). The resulting Initiator Solution 3 and each of the thermal cationic polymerization initiators, described in Table 2, were added to aforesaid Solution 3. After de-aerating the resulting composition employing nitrogen, included gaseous components were finally removed by vacuum degassing, whereby Holographic Recording Layer Forming Composition 3 was prepared.

In the same manner, as shown in Tables 1 and 2, Holographic Recording Layer Firming Compositions 4 - 6 were prepared.

(Holographic Recording Layer Forming Compositions 7 - 30)

The binder compounds having a reactive group capable of achieving cationic polymerization described in Table 1 were employed to prepare Solution 4. Separately, Initiator Solution 4 was prepared by mixing and dissolving each the polymerizable compound having an ethylenic double bond, photopolymerization initiator, and spectral sensitizing dye described in Tables 1 and 2. Subsequently, aforesaid Initiator Solution 4, as well as the thermal cationic polymerization initiator and the acid multiplying agent described in Table 2 was added to aforesaid Solution 4.
After deaerating the resulting composition employing nitrogen, included gaseous components were finally removed by vacuum degassing, whereby Holographic Recording Layer Forming Compositions 7 - 30 were prepared.

Table 1

| | Binder Compound | | Polymerizable Compound Having an Ethylenic Double Bond | | Photopolymerization Initiator | |
|---|---|---|---|---|---|---|
| | Type | Added Amount (g) | Type | Added Amount (g) | Type | Added Amount (g) |
| *1 3 | A-1/A-2/A-5 | 7.870/4.722/3.148 | B-1/B-2 | 0.878/1.313 | C-1 | 0.126 |
| *1 4 | A-1/A-2/A-5 | 7.870/4.722/3.148 | B-1/B-2 | 0.878/1.313 | C-1 | 0.126 |
| *1 5 | A-1/A-2/A-5 | 7.870/4.722/3.148 | B-1/B-2 | 0.878/1.313 | C-1 | 0.126 |
| *1 6 | A-1/A-2/A-5 | 7.870/4.722/3.148 | B-1/B-2 | 0.878/1.313 | C-1 | 0.126 |
| *1 7 | A-2/A-3/A-4 | 8.657/4.328/2.755 | B-1/B-7 | 1.096/1.096 | C-3 | 0.183 |
| *1 8 | A-2/A-3/A-5 | 8.657/5.478/1.605 | B-1/B-7 | 1.096/1.096 | C-3 | 0.183 |
| *1 9 | A-2/A-3/A-6 | 8.657/4.980/2.103 | B-1/B-7 | 1.096/1.096 | C-3 | 0.183 |
| *1 10 | A-2/A-3/A-7 | 8.657/2.958/4.125 | B-1/B-7 | 1.096/1.096 | C-3 | 0.183 |
| *1 11 | A-2/A-3/A-8 | 8.657/2.083/5.000 | B-1/B-7 | 1.096/1.096 | C-3 | 0.183 |
| *1 12 | A-2/A-3/A-9 | 8.657/3.518/3.565 | B-1/B-7 | 1.096/1.096 | C-3 | 0.183 |
| *1 13 | A-2/A-3/A-7 | 8.657/2.958/4.125 | B-2/B-3 | 0.986/1.206 | C-2 | 0.142 |
| *1 14 | A-2/A-3/A-7 | 8.657/2.958/4.125 | B-2/B-4 | 0.986/1.206 | C-2 | 0.142 |
| *1 15 | A-2/A-3/A-7 | 8.657/2.958/4.125 | B-1/B-5 | 1.206/0.986 | C-3 | 0.183 |
| *1 16 | A-2/A-3/A-7 | 8.657/2.958/4.125 | B-1/B-6 | 1.206/0.986 | C-3 | 0.183 |
| *1 17 | A-2/A-3/A-7 | 8.657/2.958/4.125 | B-1/B-7 | 1.206/0.986 | C-3 | 0.183 |
| *1 18 | A-2/A-3/A-7 | 8.657/2.958/4.125 | B-1/B-8 | 1.206/0.986 | C-3 | 0.183 |
| *1 19 | A-2/A-3/A-7 | 8.657/2.958/4.125 | B-1/B-7 | 1.206/0.986 | C-4 | 0.148 |
| *1 20 | A-2/A-3/A-7 | 8.657/2.958/4.125 | B-1/B-7 | 1.206/0.986 | C-4 | 0.148 |
| *1 21 | A-2/A-3/A-7 | 8.657/2.958/4.125 | B-1/B-7 | 1.206/0.986 | C-4 | 0.148 |
| *1 22 | A-2/A-3/A-7 | 8.657/2.958/4.125 | B-1/B-7 | 1.206/0.986 | C-4 | 0.148 |
| *1 23 | A-10/A-12 | 7.870/7.870 | B-1/B-5 | 1.206/0.986 | C-1 | 0.126 |
| *1 24 | A-10/A-12 | 7.870/7.870 | B-1/B-5 | 1.206/0.986 | C-1 | 0.126 |
| *1 25 | A-10/A-12 | 7.870/7.870 | B-1/B-5 | 1.206/0.986 | C-1 | 0.126 |
| *1 26 | A-10/A-12 | 7.870/7.870 | B-1/B-5 | 1.206/0.986 | C-5 | 0.109 |
| *1 27 | A-10/A-12 | 7.870/7.870 | B-1/B-5 | 1.206/0.986 | C-5 | 0.109 |
| *1 28 | A-10/A-12 | 7.870/7.870 | B-1/B-5 | 1.206/0.986 | C-5 | 0.109 |
| *1 29 | A-11 | 15.740 | B-1/B-5 | 1.206/0.986 | C-1 | 0.126 |
| *1 30 | A-11 | 15.740 | B-1/B-5 | 1.206/0.986 | C-5 | 0.109 |
| *1 31 | A-2/A-3/A-4 | 8.657/4.328/2.755 | B-1/B-7 | 1.096/1.096 | C-3 | 0.183 |
| *1 32 | A-2/A-3/A-5 | 8.657/5.478/1.605 | B-1/B-7 | 1.096/1.096 | C-3 | 0.183 |

*1; Holographic Recording Layer Forming Composition

Table 2

| | | Spectral Sensitizing Dye | | Thermal Cationic Polymerization Initiator | | Acid Multiplying Agent | |
|---|---|---|---|---|---|---|---|
| | | Type | Added Amount (g) | Type | Added Amount (g) | Type | Added Amount (g) |
| *1 | 3 | S-2 | 0.00126 | D-4 | 0.596 | - | - |
| *1 | 4 | S-2 | 0.00126 | D-5 | 0.665 | - | - |
| *1 | 5 | S-2 | 0.00126 | D-6 | 0.757 | - | - |
| *1 | 6 | S-2 | 0.00126 | D-8 | 0.605 | - | - |
| *1 | 7 | - | - | D-6 | 0.757 | Z-1 | 0.199 |
| *1 | 8 | - | - | D-6 | 0.757 | Z-1 | 0.199 |
| *1 | 9 | - | - | D-6 | 0.757 | Z-1 | 0.199 |
| *1 | 10 | - | - | D-6 | 0.757 | Z-1 | 0.199 |
| *1 | 11 | - | - | D-6 | 0.757 | Z-1 | 0.199 |
| *1 | 12 | - | - | D-6 | 0.757 | Z-1 | 0.199 |
| *1 | 13 | - | - | D-7 | 0.670 | Z-1 | 0.199 |
| *1 | 14 | - | - | D-7 | 0.670 | Z-1 | 0.199 |
| *1 | 15 | - | - | D-7 | 0.670 | Z-1 | 0.199 |
| *1 | 16 | - | - | D-7 | 0.670 | Z-1 | 0.199 |
| *1 | 17 | - | - | D-7 | 0.670 | Z-1 | 0.199 |
| *1 | 18 | - | - | D-7 | 0.670 | Z-1 | 0.199 |
| *1 | 19 | S-2 | 0.00275 | D-1 | 0.552 | Z-2 | 0.205 |
| *1 | 20 | S-2 | 0.00275 | D-2 | 0.520 | Z-2 | 0.205 |
| *1 | 21 | S-2 | 0.00275 | D-3 | 0.542 | Z-2 | 0.205 |
| *1 | 22 | S-2 | 0.00275 | D-7 | 0.804 | Z-2 | 0.205 |
| *1 | 23 | S-3 | 0.01594 | D-7 | 0.670 | - | - |
| *1 | 24 | S-4 | 0.00849 | D-7 | 0.670 | - | - |
| *1 | 25 | S-5 | 0.00111 | D-7 | 0.670 | - | - |
| *1 | 26 | S-3 | 0.00119 | D-7 | 0.670 | - | - |
| *1 | 27 | S-4 | 0.00110 | D-7 | 0.670 | - | - |
| *1 | 28 | S-5 | 0.00133 | D-7 | 0.670 | - | - |
| *1 | 29 | S-5 | 0.00111 | D-7 | 0.670 | - | - |
| *1 | 30 | S-5 | 0.00133 | D-7 | 0.670 | - | - |
| *1 | 31 | - | - | D-6 | 0.757 | - | - |
| *1 | 32 | - | - | D-6 | 0.757 | - | - |
| *1; Holographic Recording Layer Forming Composition | | | | | | | |

<Preparation of Holographic Recording Media>

(Preparation Method 1)

As the first and second substrates, the one side surface of a glass plate having a thickness of 0.5 mm was

subjected to an anti-reflection treatment so as to make a reflectance of 0.1% against the vertical incident light of a wavelength of 532 nm. The holographic recording layer forming compositions described in table 4 were applied on the surface without an anti-reflection treatment of the first substrate, employing a polyethylene terephthalate sheet having the thickness described in table 4 as a spacer, and subsequently the surface without an anti-reflection treatment of the second substrate was laminated onto the holographic recording layer forming composition not as to occlude an air layer to result in lamination of the first and second substrates while sandwiching the spacer. Finally, the edges were sealed with a moisture-curable adhesive and the samples were kept at room temperature for 24 hours to prepare the holographic recording media.

(Preparation Method 2)

The holographic recording media described in tables 4 and 5 were prepared in a similar manner to preparation method 1 by being kept at 45 °C for 24 hours after the edges had been sealed with a moisture-curable adhesive.

(Preparation Method 3)

The first substrate was prepared by subjecting the one side surface of a glass plate having a thickness of 0.5 mm to an anti-reflection treatment so as to make a reflectance of 0.1% against the vertical incident light of a wavelength of 532 nm, and the second substrate was prepared by subjecting the one side surface of a glass plate having a thickness of 0.5 mm to aluminum evaporation so as to make a reflectance of 90% against the vertical incident light of a wavelength of 532 nm. Next, the holographic recording layer forming compositions described in table 6 were applied on the surface without an anti-reflection treatment of the first substrate, employing a polyethylene terephthalate sheet having the thickness described in table 6 as a spacer, and subsequently the surface with aluminum evaporation of the second substrate was laminated onto the holographic recording layer forming composition not as to occlude an air layer to result in lamination of the first and second substrates while sandwiching the spacer. Finally, the edges were sealed with a moisture-curable adhesive and the samples were kept at room temperature for 24 hours to prepare the holographic recording media.

(Preparation Method 4)

The holographic recording media described in tables 6 were prepared in a similar manner to preparation method 3 by being kept at 45 °C for 24 hours after the edges had been sealed with a moisture-curing type adhesive.

Table 3

| Holographic Recording Medium No. | Holographic Recording LayerForming Composition No. | Preparation Method | Thermal Processing Condition | | Recording Layer Thickness (mm) | Dh/ (d1+d2) |
|---|---|---|---|---|---|---|
| | | | Temperature (°C) | Time | | |
| Recording Medium 1 | Composition | Preparation Method 1 | 25 | 24 hours | 0.20 | 0.20 |
| Recording Medium 2 | Composition 2 | Preparation Method 1 | 25 | 24 hours | 0.20 | 0.20 |
| Recording Medium 3 | Composition 2 | Preparation Method 1 | 25 | 24 hours | 0.50 | 0.50 |
| Recording Medium 4 | Composition 15 | Preparation Method 1 | 25 | 24 hours | 0.20 | 0.20 |
| Recording Medium 5 | Composition 16 | Preparation Method 1 | 25 | 24 hours | 0.20 | 0.20 |
| Recording Medium 6 | Composition 17 | Preparation Method 1 | 25 | 24 hours | 0.20 | 0.20 |
| Recording Medium 7 | Composition 18 | Preparation Method 1 | 25 | 24 hours | 0.20 | 0.20 |

Table continued

| Holographic Recording Medium No. | Holographic Recording LayerForming Composition No. | Preparation Method | Thermal Processing Condition | | Recording Layer Thickness (mm) | Dh/ (d1+d2) |
|---|---|---|---|---|---|---|
| | | | Temperature (°C) | Time | | |
| Recording Medium 8 | Composition 19 | Preparation Method 1 | 25 | 24 hours | 0.20 | 0.20 |
| Recording Medium 9 | Composition 20 | Preparation Method 1 | 25 | 24 hours | 0.20 | 0.20 |
| Recording Medium 10 | Composition 21 | Preparation Method 1 | 25 | 24 hours | 0.20 | 0.20 |
| Recording Medium 11 | Composition 22 | Preparation Method 1 | 25 | 24 hours | 0.20 | 0.20 |
| Recording Medium 12 | Composition 1 | Preparation Method 2 | 40 | 6 hours | 0.20 | 0.20 |
| Recording Medium 13 | Composition 2 | Preparation Method 2 | 40 | 6 hours | 0.20 | 0.20 |
| Recording Medium 14 | Composition 3 | Preparation Method 2 | 80 | 0.4 hours | 0.20 | 0.20 |
| Recording Medium 15 | Composition 4 | Preparation Method 2 | 80 | 0.4 hours | 0.20 | 0.20 |
| Recording Medium 16 | Composition 5 | Preparation Method 2 | 80 | 0.4 hours | 0.20 | 0.20 |
| Recording Medium 17 | Composition 6 | Preparation Method 2 | 80 | 0.4 hours | 0.20 | 0.20 |
| Recording Medium 18 | Composition 7 | Preparation Method 2 | 40 | 12 hours | 0.20 | 0.20 |
| Recording Medium 19 | Composition 8 | Preparation Method 2 | 40 | 12 hours | 0.20 | 0.20 |
| Recording Medium 20 | Composition 8 | Preparation Method 2 | 50 | 5 hours | 0.20 | 0.20 |
| Recording Medium 21 | Composition 8 | Preparation Method 2 | 60 | 2.5 hours | 0.20 | 0.20 |
| Recording Medium 22 | Composition 9 | Preparation Method 2 | 40 | 12 hours | 0.20 | 0.20 |
| Recording Medium 23 | Composition 10 | Preparation Method 2 | 440 | 12 hours | 0.20 | 0.20 |
| Recording Medium 24 | Composition 10 | Preparation Method 2 | 40 | 12 hours | 0.50 | 0.50 |
| Recording Medium 25 | Composition 11 | Preparation Method 2 | 40 | 12 hours | 0.20 | 0.20 |
| Recording Medium 26 | Composition 12 | Preparation Method 2 | 40 | 12 hours | 0.20 | 0.20 |
| Recording Medium 27 | Composition 13 | Preparation Method 2 | 40 | 12 hours | 0.20 | 0.20 |

Table continued

| Holographic Recording Medium No. | Holographic Recording LayerForming Composition No. | Preparation Method | Thermal Processing Condition | | Recording Layer Thickness (mm) | Dh/ (d1+d2) |
|---|---|---|---|---|---|---|
| | | | Temperature (°C) | Time | | |
| Recording Medium 28 | Composition 14 | Preparation Method 2 | 40 | 12 hours | 0.20 | 0.20 |
| Recording Medium 29 | Composition 15 | Preparation Method 2 | 40 | 12 hours | 0.20 | 0.20 |
| Recording Medium 30 | Composition 16 | Preparation Method 2 | 40 | 12 hours | 0.20 | 0.20 |
| Recording Medium 31 | Composition 17 | Preparation Method 2 | 40 | 12 hours | 0.20 | 0.20 |
| Recording Medium 32 | Composition 18 | Preparation Method 2 | 40 | 12 hours | 0.20 | 0.20 |
| Recording Medium 33 | Composition Preparation 23 | Method 2 | 40 | 24 hours | 0.50 | 0.50 |
| Recording Medium 34 | Composition 24 | Preparation Method 2 | 40 | 24 hours | 0.50 | 0.50 |
| Recording Medium 35 | Composition 25 | Preparation Method 2 | 40 | 24 hours | 0.50 | 0.50 |
| Recording Medium 36 | Composition 26 | Preparation Method 2 | 40 | 24 hours | 0.50 | 0.50 |
| Recording Medium 37 | Composition 27 | Preparation Method 2 | 40 | 24 hours | 0.50 | 0.50 |
| Recording Medium 38 | Composition 28 | Preparation Method 2 | 40 | 24 hours | 0.50 | 0.50 |
| Recording Medium 39 | Composition 29 | Preparation Method 2 | 40 | 24 hours | 0.50 | 0.50 |
| Recording Medium 40 | Composition 30 | Preparation Method 2 | 40 | 24 hours | 0.50 | 0.50 |
| Recording Medium 66 | Composition 31 | Preparation Method 2 | 40 | 12 hours | 0.20 | 0.20 |
| Recording Medium 67 | Composition 32 | Preparation Method 2 | 40 | 12 hours | 0.20 | 0.20 |

Table 4

| Holo-graphic Recording Medium No. | Holographic Recording LayerForming Composition No. | Preparation Method | Thermal Processing Condition | | Recording Layer Thickness (mm) | Dh/ (d1+d2) |
|---|---|---|---|---|---|---|
| | | | Temperature (°C) | Time | | |
| Recording Medium 41 | Composition 1 | Preparation Method 3 | 25 | 24 hours | 0.20 | 0.20 |

Table continued

| Holo-graphic Recording Medium No. | Holographic Recording LayerForming Composition No. | Preparation Method | Thermal Processing Condition | | Recording Layer Thickness (mm) | Dh/ (d1+d2) |
|---|---|---|---|---|---|---|
| | | | Temperature (°C) | Time | | |
| Recording Medium 42 | Composition 2 | Preparation Method 3 | 25 | 24 hours | 0.20 | 0.20 |
| Recording Medium 43 | Composition 15 | Preparation Method 3 | 25 | 24 hours | 0.20 | 0.20 |
| Recording Medium 44 | Composition 16 | Preparation Method 3 | 25 | 24 hours | 0.20 | 0.20 |
| Recording Medium 45 | Composition 21 | Preparation Method 3 | 25 | 24 hours | 0.20 | 0.20 |
| Recording Medium 46 | Composition 22 | Preparation Method 3 | 25 | 24 hours | 0.20 | 0.20 |
| Recording Medium 47 | Composition 1 | Preparation Method 4 | 40 | 6 hours | 0.20 | 0.20 |
| Recording Medium 48 | Composition 2 | Preparation Method 4 | 40 | 6 hours | 0.20 | 0.20 |
| Recording Medium 49 | Composition 3 | Preparation Method 4 | 80 | 0.4 hours | 0.20 | 0.20 |
| Recording Medium 50 | Composition 5 | Preparation Method 4 | 80 | 0.4 hours | 0.20 | 0.20 |
| Recording Medium 51 | Composition 6 | Preparation Method 4 | 80 | 0.4 hours | 0.20 | 0.20 |
| Recording Medium 52 | Composition 7 | Preparation Method 4 | 40 | 12 hours | 0.20 | 0.20 |
| Recording Medium 53 | Composition 8 | Preparation Method 4 | 40 | 12 hours | 0.20 | 0.20 |
| Recording Medium 54 | Composition Preparation 15 | Method 4 | 40 | 12 hours | 0.20 | 0.20 |
| Recording Medium 55 | Composition 16 | Preparation Method 4 | 40 | 12 hours | 0.20 | 0.20 |
| Recording Medium 56 | Composition 17 | Preparation Method 4 | 40 | 12 hours | 0.20 | 0.20 |
| Recording Medium 57 | Composition 18 | Preparation Method 4 | 40 | 12 hours | 0.20 | 0.20 |

| | | | | | | |
|---|---|---|---|---|---|---|
| Recording Medium 58 | Composition 23 | Preparation Method 4 | 40 | 24 hours | 0.50 | 0.50 |
| Recording Medium 59 | Composition 24 | Preparation Method 4 | 40 | 24 hours | 0.50 | 0.50 |
| Recording Medium 60 | Composition 25 | Preparation Method 4 | 40 | 24 hours | 0.50 | 0.50 |
| Recording Medium 61 | Composition 26 | Preparation Method 4 | 40 | 24 hours | 0.50 | 0.50 |
| Recording Medium 62 | Composition 27 | Preparation Method 4 | 40 | 24 hours | 0.50 | 0.50 |
| Recording Medium 63 | Composition 28 | Preparation Method 4 | 40 | 24 hours | 0.50 | 0.50 |

Table continued

| | | | | | | |
|---|---|---|---|---|---|---|
| Recording Medium 64 | Composition 29 | Preparation Method 4 | 40 | 24 hours | 0.50 | 0.50 |
| Recording Medium 65 | Composition 30 | Preparation Method 4 | 40 | 24 hours | 0.50 | 0.50 |
| Recording Medium 68 | Composition 31 | Preparation Method 4 | 40 | 12 hours | 0.20 | 0.20 |
| Recording Medium 69 | Composition 32 | Preparation Method 4 | 40 | 12 hours | 0.20 | 0.20 |

<Recording on Holographic Recording Media and Evaluation>

(Recording on Holographic Recording Media and Evaluation 1)

Holographic recording media prepared above, on which series of multiple hologram has been written according to the procedure described in USP No. 5,719,691, were measured and evaluated with respect to sensitivity (recording energy) and a refractive index contrast according to the following methods, and the results obtained are shown in tables 7 and 8.

(Measurement of Sensitivity)

Under safe light, holographic recording media were holographic exposed at an energy of 0.1 - 50 $mJ/cm^2$ according to the digital pattern which was displayed by a holography producing apparatus equipped with a Nd:YAG laser (532 nm) which results in formation of holograms. Next, employing laser (532 nm) as the reference light, the generated Nd:YAG reproducing light was read out with CCD, and the minimum exposure amount to reproduce a satisfactory digital pattern was designated as a sensitivity (S).

(Evaluation of Contraction Resistance)

Contraction resistance was represented by a contraction ratio determined employing the method described below.

Fig. 1 is a schematic view showing the principle of a measurement apparatus which determines the contraction ratio. Namely, the light emitting point of a white illumination light source which illuminates hologram 3 is represented by 01, while the eye position of the observer is represented by 02. In the measurement apparatus, white illumination light source 4 is installed at light emitting point 01, while spectroscope 5 is installed at eye position 02. Spectroscope 5 is connected to personal computer 6, and movable pinhole plate 7, provided with pinhole 8 which only passes some of light, is installed on the upper surface of hologram 3 which determines the luminance distribution of the specific spectral wavelengths. Movable pinhole plate 7 is attached to an XY stage (not shown) and is structured to be movable in any desired direction.

Namely, when movable pinhole plate 7 is positioned at point P(I, J), the angle to the line from the center of pinhole 8 to white illumination light source 4 is represented by θc, and angle to spectroscope 5 is represented by θi. The region of point P(I, J) of hologram 3 is subjected to illumination from the θc angle employing illumination light 9, and regenerated light 11 is emitted in the θi direction. Regenerated light 11 is subjected to spectrometry employing spectroscope 5, whereby a wavelength resulting in maximum luminance is designated as regenerated wavelength λc at P(I, J). By employing the aforesaid relationship, θc, θi, and λc at each point of hologram 3 are determined while moving pinhole plate 7.

Further, when the contraction ratio of a hologram at point P(I, J) is represented by M(I, J), hologram contraction ratio M(I, J) is represented by the formula described below.

$$M(I, J) = -nc/nr \cdot \lambda r/\lambda c\ (\cos\theta c - \cos\theta i)/(\cos\theta o - \cos\theta r)$$

wherein nr is the average refractive index of a light image recording material prior to recording, nc is the average refractive index of a hologram after photographic processing, θo is the incident angle to the holographic recording medium, λr is the wavelength of a laser beam, and θr is the incident angle to the holographic recording medium.

(Evaluation of Refractive Index Contrast)

The refractive index contrast was determined from the diffraction efficiency measured according to the following

method. To measure the diffraction efficiency, a photomultiplier, which employs ART 25 Spectrometer produced by Nippon Bunko Kogyo Co., Ltd. and has a slit of 3 mm wide, was arranged on the circumference having a radius of 20 cm with the sample at the center. Monochromatic light of 0.3 mm wide was incident at an angle of 45 degrees against the sample, and the diffraction light from the sample was detected. The ratio of the maximum value other than the right reflective light to the value when directly accepting the incident light without placing a sample is defined as a diffraction efficiency, and the refractive index contrast (△n) was determined from the obtained diffraction efficiency of a hologram.

Table 5

| | Holographic Recording Medium No. | S (mJ/cm$^2$) | Contraction Ratio (%) | △n (x $10^{-3}$) |
|---|---|---|---|---|
| Comparative Examplel-1 | Recording Medium 12 | 18 | 3.3 | 2.2 |
| Comparative Example1-2 | Recording Medium 13 | 11 | 3.9 | 3.1 |
| Present Invention 1-1 | Recording Medium 14 | 7.5 | 0.4 | 4.5 |
| Present Invention 1-2 | Recording Medium 15 | 8.0 | 0.3 | 4.7 |
| Present Invention 1-3 | Recording Medium 16 | 8.5 | 0.3 | 5.1 |
| Present Invention 1-4 | Recording Medium 17 | 7.5 | 0.4 | 4.4 |
| Present Invention 1-5 | Recording Medium 18 | 1.9 | 0.3 | 4.5 |
| Present Invention 1-6 | Recording Medium 19 | 1.7 | 0.3 | 4.4 |
| Present Invention 1-7 | Recording Medium 20 | 2.5 | 0.3 | 4.8 |
| Present Invention 1-8 | Recording Medium 21 | 3.1 | 0.3 | 4.9 |
| Present Invention 1-9 | Recording Medium 22 | 1.8 | 0.3 | 4.7 |
| Present Invention 1-10 | Recording Medium 23 | 1.7 | 0.3 | 5.1 |
| Present Invention 1-11 | Recording Medium 24 | 2.3 | 0.4 | 6.5 |
| Present Invention 1-12 | Recording Medium 25 | 1.8 | 0.2 | 4.6 |
| Present Invention 1-13 | Recording Medium 26 | 2.1 | 0.2 | 4.7 |
| Present Invention 1-14 | Recording Medium 27 | 1.7 | 0.3 | 4.1 |
| Present Invention 1-15 | Recording Medium 28 | 1.6 | 0.3 | 4.3 |
| Present Invention 1-16 | Recording Medium 29 | 1.5 | 0.4 | 4.7 |
| Present Invention 1-17 | Recording Medium 30 | 1.6 | 0.4 | 4.8 |
| Present Invention 1-18 | Recording Medium 31 | 1.7 | 0.3 | 5 |
| Present Invention 1-19 | Recording Medium 32 | 1.9 | 0.2 | 5.2 |
| Present Invention 1-20 | Recording Medium 33 | 2.1 | 0.3 | 6.2 |
| - Present Invention 1-21 | Recording Medium 34 | 2.1 | 0.3 | 6.0 |
| Present Invention 1-22 | Recording Medium 35 | 1.9 | 0.2 | 5.6 |
| Present Invention 1-23 | Recording Medium 36 | 2.3 | 0.3 | 6.3 |
| Present Invention 1-24 | Recording Medium 37 | 2.2 | 0.3 | 6.2 |
| Present Invention 1-25 | Recording Medium 38 | 2.1 | 0.2 | 5.8 |
| Present Invention 1-26 | Recording Medium 39 | 1.8 | 0.2 | 5.5 |
| Present Invention 1-27 | Recording Medium 40 | 2.0 | 0.2 | 5.8 |
| Present Invention 1-28 | Recording Medium 66 | 2.0 | 0.4 | 4.3 |
| Present Invention 1-29 | Recording Medium 67 | 1.8 | 0.4 | 4.2 |

It is clear that recording media of the present invention are provided with a higher sensitivity and a higher contrast compared to comparative examples.

(Recording on Holographic Recording Media and Evaluation 2)

Holographic recording media prepared above, on which series of multiple hologram has been written according to the procedure described in USP No. 5,719,691, were measured and evaluated with respect to sensitivity (recording energy) and the aforesaid refractive index contrast according to the following methods, and the results obtained are shown in table 6.

(Measurement of Sensitivity)

Under safe light, holographic recording media were holographic exposed at an energy of 0.1 - 50 $mJ/cm^2$ according to the digital pattern which was displayed by a holography producing apparatus equipped with a Nd:YAG laser (532 nm) which resulted in formation of holograms. Next, the holographic recording media were exposed under a sunshine fade meter of 70,000 lux for 5 minutes. Under safe light and employing Nd:YAG laser (532 nm) as the reference light, the generated reproducing light of the recording media thus treated was read out with CCD, and the minimum exposure amount to reproduce a satisfactory digital pattern was designated as a sensitivity (S).

Table 6

| | Holographic Recording Medium No. | S ($mJ/cm^2$) | Contraction Ratio (%) | $\Delta n$ (x $10^{-3}$) |
|---|---|---|---|---|
| Comparative Example 2-1 | Recording Medium 1 | 25 | 3.5 | 2.4 |
| Comparative Example 2-2 | Recording Medium 2 | 15 | 4.5 | 3.3 |
| Comparative Example 2-3 | Recording Medium 3 | 25 | 4.8 | 3.9 |
| Present Invention 2-1 | Recording Medium 4 | 1.7 | 0.4 | 4.8 |
| Present Invention 2-2 | Recording Medium 5 | 1.8 | 0.3 | 4.8 |
| Present Invention 2-3 | Recording Medium 6 | 1.9 | 0.2 | 5.1 |
| Present Invention 2-4 | Recording Medium 7 | 2.2 | 0.2 | 5.3 |
| Present Invention 2-5 | Recording Medium 8 | 2.1 | 0.2 | 5.1 |
| Present Invention 2-6 | Recording Medium 9 | 2.2 | 0.2 | 5.1 |
| Present Invention 2-7 | Recording Medium 10 | 2.2 | 0.2 | 5.3 |
| Present Invention 2-8 | Recording Medium 11 | 2.3 | 0.2 | 5.5 |
| Present Invention 2-9 | Recording Medium 29 | 1.6 | 0.3 | 4.8 |
| Present Invention 2-10 | Recording Medium 30 | 1.7 | 0.3 | 4.8 |
| Present Invention 2-11 | Recording Medium 31 | 1.8 | 0.2 | 5.1 |
| Present Invention 2-12 | Recording Medium 32 | 2.0 | 0.2 | 5.2 |
| Present Invention 2-13 | Recording Medium 33 | 2.2 | 0.2 | 6.2 |
| Present Invention 2-14 | Recording Medium 34 | 2.2 | 0.2 | 6.1 |
| Present Invention 2-15 | Recording Medium 35 | 1.9 | 0.2 | 5.7 |
| Present Invention 2-16 | Recording Medium 36 | 2.4 | 0.2 | 6.3 |
| Present Invention 2-17 | Recording Medium 37 | 2.3 | 0.2 | 6.3 |
| Present Invention 2-18 | Recording Medium 38 | 2.1 | 0.2 | 5.9 |
| Present Invention 2-19 | Recording Medium 39 | 1.9 | 0.2 | 5.6 |
| Present Invention 2-20 | Recording Medium 40 | 2.1 | 0.2 | 5.9 |

It is also clear that recording media of the present invention are provided with a higher sensitivity, a lower level

of shrinkage and a higher contrast compared to comparative examples.

(Recording on Holographic Recording Media and Evaluation 3)

Holographic recording media prepared above, on which series of multiple hologram have been written according to the procedure described in JP-A No. 2002-123949, were measured and evaluated with respect to sensitivity (recording energy) and the aforesaid refractive index contrast according to the following methods, and the results obtained are shown in table 10.

(Measurement of Sensitivity)

Under safe light, holographic recording media were holographic exposed at an energy of 0.1 - 50 $mJ/cm^2$ according to the digital pattern which was displayed by a holography producing apparatus equipped with a Nd:YAG laser (532 nm), which resulted in formation of holograms. Next, the holographic recording media were exposed under a sunshine fade meter of 70,000 lux for 5 minutes. Under safe light and employing Nd:YAG laser (532 nm) as the reference light, the generated reproducing light of the recording media thus treated was read out with CCD, and the minimum exposure amount to reproduce a satisfactory digital pattern was designated as a sensitivity (S).

Table 7

| | Holographic Recording Medium No. | S ($mJ/cm^2$) |
|---|---|---|
| Comparative Example 3-1 | Recording Medium 41 | 20 |
| Comparative Example 3-2 | Recording Medium 42 | 12 |
| Present Invention 3-1 | Recording Medium 43 | 1.4 |
| Present Invention 3-2 | Recording Medium 44 | 1.6 |
| Present Invention 3-3 | Recording Medium 45 | 2.1 |
| Present Invention 3-4 | Recording Medium 46 | 2.1 |
| Comparative Example 3-3 | Recording Medium 47 | 16 |
| Comparative Example 3-4 | Recording Medium 48 | 10 |
| Present Invention 3-5 | Recording Medium 49 | 6.5 |
| Present Invention 3-6 | Recording Medium 50 | 7.5 |
| Present Invention 3-7 | Recording Medium 51 | 7.0 |
| Present Invention 3-8 | Recording Medium 52 | 1.7 |
| Present Invention 3-9 | Recording Medium 53 | 1.5 |
| Present Invention 3-10 | Recording Medium 54 | 1.5 |
| Present Invention 3-11 | Recording Medium 55 | 1.6 |
| Present Invention 3-12 | Recording Medium 56 | 1.6 |
| Present Invention 3-13 | Recording Medium 57 | 1.8 |
| Present Invention 3-14 | Recording Medium 58 | 5.7 |
| Present Invention 3-15 | Recording Medium 59 | 5.5 |
| Present Invention 3-16 | Recording Medium 60 | 5.1 |
| Present Invention 3-17 | Recording Medium 61 | 5.9 |
| Present Invention 3-18 | Recording Medium 62 | 5.9 |
| Present Invention 3-19 | Recording Medium 63 | 5.4 |
| Present Invention 3-20 | Recording Medium 64 | 5.1 |
| Present Invention 3-21 | Recording Medium 65 | 5.3 |
| Present Invention 3-22 | Recording Medium 68 | 1.8 |
| Present Invention 3-23 | Recording Medium 69 | 1.5 |

It is clear that the recording media of the present invention exhibit a higher sensitivity compared to the comparative examples.

The present invention can provide holographic recording media having a high sensitivity as well as a low shrinkage ratio, and a holographic recording method utilizing them.

## Claims

1. A holographic recording medium comprising a first substrate and a second substrate having a holographic recording layer between the first substrate and the second substrate, the holographic recording layer containing:

   (A) a binder compound having a reactive group capable of cationic polymerization;
   (B) a polymerizable compound having an ethylenic double bond in the molecule;
   (C) a photoinitiator; and
   (D) a cross-linking agent which reacts with the reactive group in the binder compound, wherein the cross-linking agent is a thermal cationic polymerization initiator.

2. The holographic recording medium of claim 1, wherein the thermal cationic polymerization initiator is a compound represented by Formula (1) or Formula (2):

   Formula (1)

   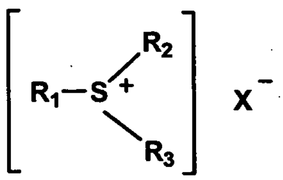

   wherein R1 is a substituted or unsubstituted aromatic group, each R2 and R3 is independently a substituted or unsubstituted alkyl, cycloalkyl, aralkyl group, and $X^-$ is a counter anion;

   Formula (2)

   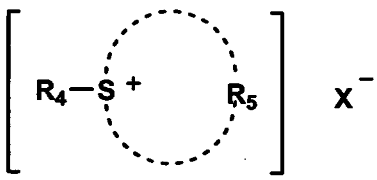

   wherein R4 is a substituted or unsubstituted alkyl, cycloalkyl, aralkyl group, R5 is a substituted or unsubstituted hydrocarbon group which forms 5 or 6-membered ring with sulfur, and $X^-$ is a counter anion.

3. The holographic recording medium of claim 2, wherein the holographic recording layer further contains an acid multiplying agent.

4. The holographic recording medium of claim 1, wherein the holographic recording layer further contains a spectral sensitizing dye.

5. The holographic recording medium of claim 1, wherein the reactive group in the binder compound is selected from the group consisting of an epoxy, oxetane, vinyl ether, alkenyl ether, allene ether and keteneacetal group.

6. The holographic recording medium of claim 5, wherein the binder compound contains an oxetane group in the molecule.

**7.** The holographic recording medium of claim 5, wherein the binder compound is a liquid at 20° C or has a melting point of not more than 100 ° C.

**8.** The holographic recording medium of claim 1, wherein the ethylenic double bond in the polymerizable compound is an acryloyl or methacryloyl group.

**9.** The holographic recording medium of claim 1, wherein the polymerizable compound has a refractive index of not less than 1.55.

**10.** The holographic recording medium of claim 1, wherein a thickness of the first substrate (d1), a thickness of the second substrate (d2) and a thickness of the holographic recording layer (Dh) satisfy the following formula:

$$0.15 \leq Dh/(d1 + d2) \leq 2.0$$

**11.** The holographic recording medium of claim 10, wherein the thickness of the holographic recording layer (Dh) is 200 μm to 2.0 mm.

**12.** The holographic recording medium of claim 10, wherein the thickness of the first substrate (d1) and the thickness of the second substrate (d2) satisfy the following formula:

$$d1 \leq d2$$

**13.** The holographic recording medium of claim 1, wherein the first substrate is transparent and has an antireflective outer surface and an inner surface, the antireflective outer surface being opposite to the inner surface and the inner surface facing the holographic recording layer.

**14.** The holographic recording medium of claim 1, wherein the first substrate is a glass plate.

**15.** The holographic recording medium of claim 1, wherein an inner surface or an outer surface of the second substrate is coated with a reflective layer having a reflective index of not less than 70%, the inner surface being a surface which has the holographic recording layer thereon.

**16.** The holographic recording medium of claim 1, wherein a shape of the holographic recording medium is a disc form.

**17.** The holographic recording medium of claim 1, wherein a shape of the holographic recording medium is a card form.

**18.** A method of forming a holographic image using a holographic recording medium comprising a first substrate and a second substrate having a holographic recording layer between the two substrate, the holographic recording layer containing:

(A) a binder compound having a reactive group which is capable of cationic polymerization;
(B) a polymerizable compound having an ethylenic double bond in the molecule;
(C) a photoinitiator; and
(D) a cross-linking agent which reacts with the reactive group in the binder compound and further a thermal cationic polymerization initiator,

the method comprising the steps of:

(i) irradiating the holographic recording medium with a first light so as to cross-link the binder compound and the cross-linking agent, provided that the first light has not a property of activating the photoinitiator;
(ii) irradiating the holographic recording medium with a second light based on information to be recorded so as to activate the photoinitiator;
(iii) polymerizing the activated photoinitiator with the polymerizable compound(B) to form the holographic image.

**19.** The holographic image forming method of claim 18, comprising further the step of:

(iv) irradiating the holographic recording medium with a light or subjecting the holographic recording medium so as to stabilize the holographic image after completion of the step (iii).

**20.** A method of forming a holographic image using a holographic recording medium comprising a first substrate and a second substrate having a holographic recording layer between the two substrate, the holographic recording layer containing:

(A) a binder compound having a reactive group which is capable of cationic polymerization;
(B) a polymerizable compound having an ethylenic double bond in the molecule;
(C) a photoinitiator; and
(D) a cross-linking agent which reacts with the reactive group in the binder compound and further a thermal cationic polymerization initiator,

the method comprising the steps of:

(i) irradiating the holographic recording medium with a light based on information to be recorded so as to activate the photoinitiator;
(ii) polymerizing the activated photoinitiator with the polymerizable compound to form the holographic image; and
(iii) irradiating the holographic recording medium with a light or subjecting the holographic recording medium so as to stabilize the holographic image after completion of the step (ii).

FIG. 1

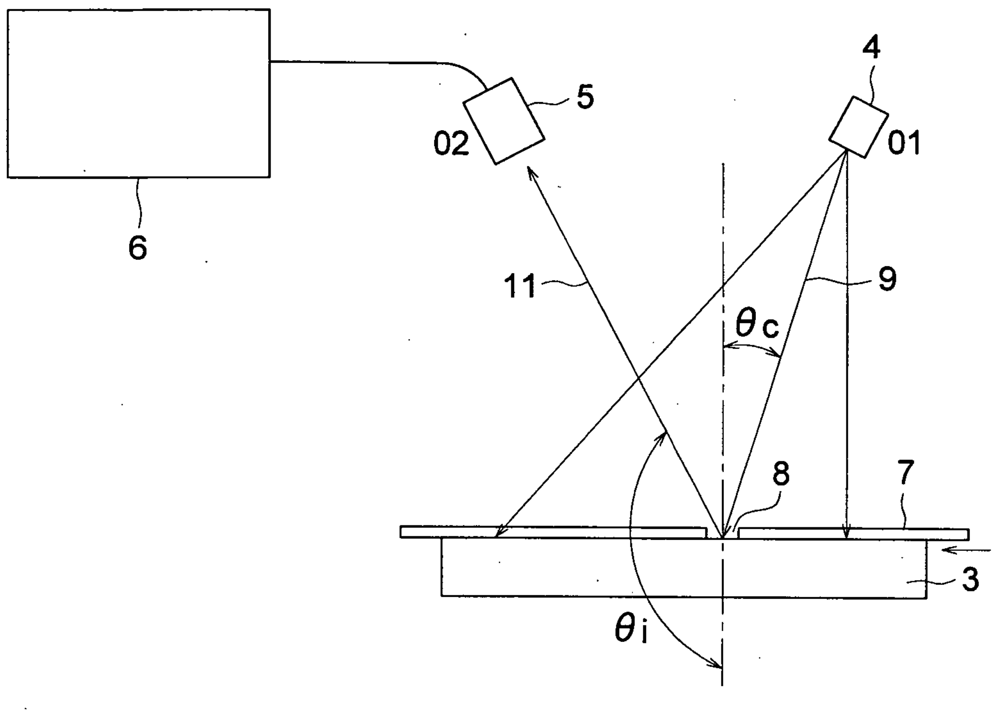

## INTERNATIONAL SEARCH REPORT

International application No.
PCT/JP2004/004065

A. CLASSIFICATION OF SUBJECT MATTER
Int.Cl[7] G03H1/02, G03H1/04

According to International Patent Classification (IPC) or to both national classification and IPC

B. FIELDS SEARCHED

Minimum documentation searched (classification system followed by classification symbols)
Int.Cl[7] G03H1/02, G03H1/04

Documentation searched other than minimum documentation to the extent that such documents are included in the fields searched

| | | | |
|---|---|---|---|
| Jitsuyo Shinan Koho | 1926-1996 | Toroku Jitsuyo Shinan Koho | 1994-2004 |
| Kokai Jitsuyo Shinan Koho | 1971-2004 | Jitsuyo Shinan Toroku Koho | 1996-2004 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>Y | JP 8-101501 A (Nippon Paint Co., Ltd.),<br>16 April, 1996 (16.04.96),<br>Full text; all drawings; particularly, Claim 1;<br>Par. Nos. [0046] to [0047]<br>(Family: none) | 1-5,7-17,20<br>6,18-19 |
| Y | JP 11-352303 A (Lucent Technologies Inc.),<br>24 December, 1999 (24.12.99),<br>Full text; all drawings; particularly,<br>Claims 1 to 2, 7 to 8, 12 to 13, 18<br>& EP 945762 A1 & US 6103454 A<br>& US 6482551 B1 & KR 99078200 A<br>& KR 343202 B | 1-5,7-20 |

[X] Further documents are listed in the continuation of Box C.  [ ] See patent family annex.

* Special categories of cited documents:

"A" document defining the general state of the art which is not considered to be of particular relevance

"E" earlier application or patent but published on or after the international filing date

"L" document which may throw doubts on priority claim(s) or which is cited to establish the publication date of another citation or other special reason (as specified)

"O" document referring to an oral disclosure, use, exhibition or other means

"P" document published prior to the international filing date but later than the priority date claimed

"T" later document published after the international filing date or priority date and not in conflict with the application but cited to understand the principle or theory underlying the invention

"X" document of particular relevance; the claimed invention cannot be considered novel or cannot be considered to involve an inventive step when the document is taken alone

"Y" document of particular relevance; the claimed invention cannot be considered to involve an inventive step when the document is combined with one or more other such documents, such combination being obvious to a person skilled in the art

"&" document member of the same patent family

| | |
|---|---|
| Date of the actual completion of the international search<br>04 June, 2004 (04.06.04) | Date of mailing of the international search report<br>22 June, 2004 (22.06.04) |
| Name and mailing address of the ISA/<br>Japanese Patent Office<br><br>Facsimile No. | Authorized officer<br><br>Telephone No. |

Form PCT/ISA/210 (second sheet) (January 2004)

INTERNATIONAL SEARCH REPORT

International application No.
PCT/JP2004/004065

C (Continuation). DOCUMENTS CONSIDERED TO BE RELEVANT

| Category* | Citation of document, with indication, where appropriate, of the relevant passages | Relevant to claim No. |
|---|---|---|
| Y | JP 3-237107 A (Sanshin Chemical Industry Co., Ltd.), 23 October, 1991 (23.10.91), Full text; all drawings (Family: none) | 2 |
| Y | JP 2001-228610 A (Showa Denko Kabushiki Kaisha), 24 August, 2001 (24.08.01), Full text; all drawings; particularly, Claim 1 (Family: none) | 6 |
| Y | JP 2003-66816 A (Dainippon Printing Co., Ltd.), 05 March, 2003 (05.03.03), Full text; all drawings; particularly, Claim 1 (Family: none) | 6 |
| Y | JP 2002-123949 A (Optware Corp.), 26 April, 2002 (26.04.02), Full text; all drawings & WO 02/15176 A1 & EP 1324322 A1 & US 2004/0042374 A1 & AU 200167866 A & KR 2003019950 A & CN 1446355 A | 15,16 |
| Y | JP 2002-513981 A (OPTILINK AB.), 14 May, 2002 (14.05.02), Full text; all drawings & WO 99/57719 A1 & EP 1080466 A1 & EP 1080466 B1 & DE 6920916049 E & AU 9938402 A & CN 1308761 A & KR 2001071211 A | 15,17 |

Form PCT/ISA/210 (continuation of second sheet) (January 2004)